# EUROPÄISCHE PATENTSCHRIFT

(11) **EP 3 870 529 B1**
(45) Veröffentlichungstag und Bekanntmachung des Hinweises auf die Patenterteilung: **05.10.2022**
(21) Anmeldenummer: 19784067.1
(22) Anmeldetag: 14.10.2019
(51) Int. Cl.: B66B 23/00, G06F 30/13, G06F 30/17

(54) **FACHWERK-DATENSATZ EINER FAHRTREPPE ODER EINES FAHRSTEIGES**
FRAMEWORK DATA SET OF AN ESCALATOR OR MOVING WALKWAY
ENSEMBLE D'ENREGISTREMENT DE TREILLIS D'UN ESCALIER ROULANT OU D'UN TROTTOIR ROULANT

(30) Priorität: 25.10.2018 EP 18202653
(43) Veröffentlichungstag der Anmeldung: 01.09.2021
(73) Patentinhaber: INVENTIO AG, 6052 Hergiswil (CH)
(72) Erfinder: NOVACEK, Thomas, 2320 Schwechat (AT); DRAHOHS-FÖDERLER, Andreas, 2721 Bad Fischau-Brunn (AT); POHL, Barbara, 2000 Stockerau (AT); DRÖGSLER, Johannes, 2352 Gumpoldskirchen (AT); BARTONIK, Robert, 2201 Gerasdorf bei Wien (AT); BRINSKELLE, Stefan, 1210 Wien (AT)
(74) Vertreter: Inventio AG
(86) Internationale Anmeldenummer: PCT/EP2019/077715
(87) Internationale Veröffentlichungsnummer: WO 2020/083684

(56) Entgegenhaltungen:
- JP-A- 2006 188 295
- K. BHASKAR ET AL: "Design And Analysis of Escalator Frame", INTERNATIONAL JOURNAL OF ADVANCED SCIENTIFIC TECHNOLOGIES IN ENGINEERING AND MANAGEMENT SCIENCES, Bd. 2, Nr. 9, 1. September 2016 (2016-09-01), Seiten 7-13, XP055585212, ISSN: 2454-356X

## Beschreibung

Die Erfindung betrifft ein Verfahren zur Erstellung eines dreidimensionalen Fachwerk-Datensatzes einer Fahrtreppe oder eines Fahrsteiges.

Fahrtreppen und Fahrsteige sind weit verbreitete Personentransportanlagen, die beispielsweise in Bauwerken des öffentlichen Verkehrs wie Bahnhöfen, Flughäfen, U-Bahnstationen und dergleichen mehr eingesetzt werden können. Des Weiteren sind viele dieser Anlagen auch in Kaufhäusern, Shopping-Malls, Freizeitparks, usw. zu finden. Je nach Einsatzgebiet und Einsatzort unterliegen diese Personentransportanlagen unterschiedlichen Anforderungen, die einerseits durch Normenwerke wie beispielsweise die EN115-1, andererseits aber auch durch die kundenspezifischen Anforderungen wie beispielsweise die Förderleistung und die Förderhöhe vorgegeben werden.

Kernstück dieser Personentransportanlagen ist jeweils ein Tragwerk, das üblicherweise als Fachwerk ausgebildet ist. In und an dieses Fachwerk werden alle übrigen Bauteile der Fahrtreppe oder des Fahrsteiges eingebaut beziehungsweise angebaut. Die Masse dieser Bauteile, später die zu transportierende Last und seine Eigenmasse stützt das Fachwerk über Auflagestellen im Gebäude ab. Die als Fachwerk ausgebildeten Tragwerke bestehen üblicherweise aus einer Vielzahl von Profilstäben, die fachwerkartig miteinander durch Schweissen, Nieten, etc. verbunden sind. Hierbei werden die Profilstäbe nach ihrer Funktion bezeichnet, so dass ein Fachwerk Obergurte, Untergurte, Steher, Diagonalstreben, Querstreben und dergleichen mehr aufweist. Ein Tragwerk beziehungsweise Fachwerk der vorgenannten Art wird beispielsweise in der EP 3 121 143 A1 offenbart. K. BHASKAR ET AL: "Design And Analysis of Escalator Frame",INTERNATIONAL JOURNAL OF ADVANCED SCIENTIFIC TECHNOLOGIES IN ENGINEERING AND MANAGEMENT SCIENCES, Bd. 2, Nr. 9, 1. September 2016 (2016-09-01), Seiten 7-13, XP055585212,ISSN: 2454-356X, zeigt ein Verfahren zur Erstellung eines dreidimensionalen Fachwerk-Datensatzes einer Fahrtreppe mittels eines in einem Computersystem ausgeführten Computerprogramms zwecks späterer FEM-Analyse.

Aufgrund der kundenspezifischen Anforderungen weist nahezu jedes Fachwerk eine Losgrösse von Eins auf oder anders ausgedrückt, die meisten Fachwerke sind Einzelstücke. Hierbei können sie sich nur äusserst geringfügig voneinander unterscheiden, beispielsweise wenn das eine, ansonsten baugleiche Fachwerk bezüglich seiner Förderhöhe einen Zentimeter vom anderen Fachwerk unterscheidet. Deshalb ist jeweils ein individueller Konstruktionsaufwand erforderlich, um eines dieser kundenspezifischen Fachwerke herstellen zu können. Dieser individuelle Konstruktionsaufwand umfasst ein Erstellen von Produktionsunterlagen wie Zeichnungen, Stücklisten, Materiallisten und dergleichen mehr. Dies führt dazu, dass das Fachwerk einer Fahrtreppe oder eines Fahrsteiges nicht nur das grösste, sondern mit Abstand auch das teuerste Bauteil ist.

Die Aufgabe der vorliegenden Erfindung ist daher, ein Verfahren anzugeben, das den individuellen Konstruktionsaufwand für ein kundenspezifisch konfiguriertes Fachwerk wesentlich reduziert und dieses dadurch kostengünstiger hergestellt werden kann.

Diese Aufgabe wird gelöst durch ein Verfahren zur Erstellung eines dreidimensionalen Fachwerk-Datensatzes einer Fahrtreppe oder eines Fahrsteiges mittels eines in einem Computersystem ausgeführten Computerprogramms.

Mittels dieses Computerprogramms werden die folgenden Verfahrensschritte ausgeführt, wobei diese gemäss dieser Reihenfolge, aber nicht zwingenderweise in dieser Reihenfolge, abgearbeitet werden können.

In einem Verfahrensschritt werden kundenspezifische Konfigurierungsdaten ermittelt, die Angaben zumindest zur Stufenbreite und zur Förderhöhe beinhalten. Hierzu kann das Computerprogramm Schritte durchführen, die auf einem Bildschirm Eingabemasken mit Eingabefeldern erzeugen und beispielsweise die vom Kunden gewünschte Stufenbreite und Förderhöhe abfragen. Selbstverständlich kann die Stufenbreite auch aus einer gewünschten Breite der Fahrtreppe oder des Fahrsteiges oder aus einer geforderten Transportleistung errechnet werden, sofern die dazu notwendigen Grundlagen wie beispielsweise ein erforderlicher Breitenzuschlag für Führungsschienen, deren Befestigungen und für die Profile des Fachwerkes, die erforderliche Fördergeschwindigkeit und dergleichen mehr, beispielsweise in einem Regelsatz des Computerprogramms vorhanden sind.

Gegebenenfalls kann vom Computerprogramm auch auf ein vom Kunden zur Verfügung gestelltes Logfile zugegriffen werden, um entsprechende Daten aus diesem Logfile zu extrahieren. Ein solches Logfile kann beispielsweise vom Kunden mittels eines Programms erzeugt werden, welches ihm ein sogenanntes BIM-Modell (Building Information Model) zur Verfügung stellt. Solche BIM-Modelle sind digitale, dreidimensionale Hüllenmodelle von Fahrtreppen oder Fahrsteigen, die durch den Kunden mittels Eingaben konfiguriert werden und die er hernach in sein digitales, dreidimensionales Gebäudemodell einfügen kann.

In einem weiteren Verfahrensschritt kann aufgrund der kundenspezifischen Konfigurierungsdaten vom Computerprogramm ein typenspezifisches, zweidimensionales Layout vorgeschlagen werden. Dieses zweidimensionale Layout, angeordnet in einer Ebene eines dreidimensionalen Raumes, umfasst im Wesentlichen den Führungsweg einer umlaufenden Förderkette und weist vorzugsweise einen definierten Nullpunkt im dreidimensionalen Raum auf. Dieser Nullpunkt kann beliebig ausgestaltet und definiert sein, er kann beispielsweise auch als Punktewolke mit voneinander definiert beanstandeten, im dreidimensionalen Raum angeordneten Punkten vorhanden sein. Wichtig ist lediglich, dass mindestens ein Punkt im dreidimensionalen Raum mit dem zweidimensionalen Layout verknüpft ist.

Das zweidimensionale Layout ist gewissermassen eine Vorlage, die charakteristisch für einen bestimmten Fahrtreppen- oder Fahrsteigtyp ist. Um den fertigungstechnischen Aufwand zu optimieren, werden Produkte als sogenannte Typen entwickelt. Das bedeutet, dass zum Beispiel ein bestimmter Fahrtreppentyp für Förderhöhen bis sechs Meter ausgelegt ist, während ein anderer Fahrtreppentyp für Förderhöhen ab 6 Meter bis dreissig Meter ausgelegt ist. Die typenspezifischen, zweidimensionalen Layouts dieser beiden Fahrtreppentypen unterscheiden sich voneinander beispielsweise in der zulässigen Neigung des Führungsweges im geneigten Abschnitt der Fahrtreppe, in den Übergangsbogen des Führungsweges und in der Länge der horizontalen Abschnitte des Führungsweges, die in den, zu beiden Enden des geneigten Abschnitts anschliessenden Zutrittsbereichen angeordnet sind. Wenn nachfolgend Merkmale als «typenspezifisch» bezeichnet werden, sind diese immer zum entsprechenden, typenspezifischen, zweidimensionalen Layout passend.

Die in der vorliegenden Beschreibung verwendeten Lageangaben «horizontal», «vertikal» und «geneigt» beziehen sich immer auf die geplante Einbaulage des Fachwerkes in einem Bauwerk. Ferner bezieht sich das Merkmal «Förderhöhe» auf den vertikalen Abstand zwischen den beiden, in den Zutrittsbereichen angeordneten Auflagestellen, während das Merkmal «Auflageabstand» sich auf den horizontalen Abstand zwischen den beiden Auflagestellen bezieht.

Präziser umschrieben, ist das zweidimensionale Layout eine Seitenansicht des Führungsweges der Förderketten, wie er typenspezifisch an einer physischen Fahrtreppe oder an einem physischen Fahrsteig durch deren Führungsschienen vorgegeben wird.

Selbstverständlich kann das typenspezifische, zweidimensionale Layout auch durch eine manuelle Eingabe ausgewählt werden, wobei vorzugsweise vom Computerprogramm überprüft wird, ob das dem ausgewählten, zweidimensionalen Layout zugrundeliegende Produkt bestimmte kundenspezifische Konfigurierungsdaten wie beispielsweise den Auflageabstand oder die Förderhöhe erfüllen kann. Bei einer Nichterfüllung kann durch das Computerprogramm vorzugsweise eine Warnung und/oder ein Vorschlag für ein anderes Produkt beziehungsweise typenspezifisches Layout ausgegeben werden.

Das vorgeschlagene oder durch manuelle Eingabe ausgewählte, zweidimensionale Layout ist eine Vorlage, die aber noch nicht den kundenspezifischen Anforderungen genügt. Deshalb wird in einem weiteren Verfahrensschritt dieses zweidimensionale Layout ausgehend vom Nullpunkt in der Förderhöhe angepasst. Dadurch verändert sich logischerweise auch die Länge des Führungsweges.

In einem weiteren Verfahrensschritt wird der Führungsweg des in der Förderhöhe angepassten Layouts in einer Initialerfassung in Teilungsabschnitte unterteilt. Die Länge der Teilungsabschnitte entsprechen dem Abstand von zwei aufeinander folgenden Gelenkstellen einer typenspezifischen Förderkette. Hierbei kann ein Rest-Teilungsabschnitt übrigbleiben, der kleiner ist als die anderen Teilungsabschnitte. Eine typenspezifische Förderkette ist diejenige Förderkette, die für denjenigen Fahrtreppen- oder Fahrsteigtypen vorgesehen ist, der dem zweidimensionalen Layout zugrunde liegt. Die typenspezifische Förderkette ist Teil eines umlaufend in der Fahrtreppe angeordneten Stufenbandes oder im Fahrsteig angeordneten Pallettenbandes, welches nebst den Förderketten aus einer Vielzahl gleicher, wiederkehrend an der Förderkette angeordneter Bauteile wie Rollen, Stufenkörper, Paletten und dergleichen mehr besteht. Die Teilung und damit auch die Teilungsabschnitte können selbstverständlich auch auf die wiederholte Anordnung der anderen Bauteile des Stufenbandes oder Pallettenbandes bezogen sein. Anstelle einer Förderkette kann beispielsweise auch ein Riemen im Stufenband oder Pallettenband vorgesehen sein.

Falls bei der Initialerfassung ein Rest-Teilungsabschnitt vorhanden ist, wird in einem weiteren Verfahrensschritt der Führungsweg bezüglich seiner Umlauflänge soweit vergrössert, dass der Rest-Teilungsabschnitt die gleiche Länge aufweist, wie die übrigen Teilungsabschnitte. Erst dadurch kann auf dem Führungsweg eine typenspezifische Förderkette umlaufend angeordnet werden, die nur ganze Kettenlaschen (oder präziser ausgedrückt, Kettenlaschen gleicher Teilung) aufweist, ohne bereits einen vorgesehenen Spannbereich der Förderkette auszunutzen.

Da eine Förderkette üblicherweise aus schmalen und breiten Kettengliedern zusammengesetzt ist, können die Enden einer solchen Förderkette nur dann miteinander verbunden werden, wenn an der als Gelenkstelle ausgebildeten Fügungsstelle ein schmales Kettenglied auf ein breites Kettenglied trifft. Diese Bedingung setzt eine gerade Anzahl von Teilungsabschnitten beziehungsweise Gelenkstellen voraus. Bei einer ungeraden Anzahl von Teilungsabschnitten kann bei der Initialerfassung daher in einem weiteren Verfahrensschritt der Führungsweg bezüglich seiner Umlauflänge um einen weiteren Teilungsabschnitt verlängert werden.

Der Führungsweg des Layouts weist zwei Umlenkbereiche und zwischen den Umlenkbereichen einen Vorlaufabschnitt und einen Rücklaufabschnitt auf. Im Falle eines zweidimensionalen Layouts einer Fahrtreppe oder eines geneigten Fahrsteiges sind die Umlenkbereiche in den weiter oben erwähnten, horizontalen Abschnitten der Zutrittsbereiche angeordnet und der Vorlaufabschnitt und der Rücklaufabschnitt erstrecken sich in den horizontalen Abschnitten, im geneigten Abschnitt und in den Übergangsbogen zwischen den horizontalen und geneigten Abschnitten. Bei horizontal angeordneten Fahrsteigen sind die Umlenkbereiche ebenfalls in den Zutrittsbereichen angeordnet und der Vorlaufabschnitt und der Rücklaufabschnitt erstrecken sich horizontal zwischen den beiden Umlenkbereichen. Zur Vergrösserung des Führungsweges kann der Vorlaufabschnitt und der Rücklaufabschnitt verlängert werden, indem unter Beibehaltung der Förderhöhe und ausgehend vom Nullpunkt, einer der beiden Umlenkbereiche linear versetzt wird. Oder mit anderen Worten ausgedrückt, wird zur Anpassung einer oder werden beide Umlenkbereiche horizontal verschoben, bis der Rest-Teilungsabschnitt dieselbe Länge wie die anderen Teilungsabschnitte aufweist und - sofern eine Förderkette mit breiten und schmalen Kettenglieder vorgesehen ist - der Förderweg in eine gerade Anzahl von Teilungsabschnitten aufgeteilt werden kann.

In einem weiteren Verfahrensschritt können nun dem angepassten, zweidimensionalen Layout mittels eines Regelsatzes Felder vordefinierter Struktur überlagert werden. Auch diese Felder sind zweidimensionale Vorlagen, die in fachwerktypischer Anordnung Stäbe und Knoten umfassen. Das heisst, dass diese Felder einem Schnittmuster gleich, die Lage der weiter unten beschriebenen Profilstab-Datensätze in einer Ebene vorgeben. Zur Überlagerung weist der Regelsatz Anordnungsroutinen auf, mittels denen beispielsweise der Führungsweg des angepassten, zweidimensionalen Layouts analysiert wird und markante Stellen extrahiert werden, wie beispielsweise bei einer Fahrtreppe die Knickstellen zwischen den horizontalen Abschnitten und dem geneigten Abschnitt und/oder die Bogenmittelpunkte in den Umlenkbereichen.

Zur Überlagerung werden die Felder vordefinierter Struktur aus einer Gruppe umfassend ein Standardfeld, eine obere Knicksektion, eine untere Knicksektion, eine Trennsektion oder ein Ausgleichsfeld ausgewählt. Eine Knicksektion weist hierbei einen geneigten Schenkel und einen horizontalen Schenkel auf. Der Regelsatz kann beispielsweise Befehlszeilen enthalten, die zuerst eine Anordnung der beiden Knicksektionen an den Knickstellen vorgeben. Die Knicksektionen können am Führungsweg des zweidimensionalen Layouts ausgerichtet werden. Anschliessend können die horizontalen Schenkel der Knicksektionen durch eine Verschiebung bestimmter Knoten und eine damit verbundene Verlängerung von den in diese Knoten mündenden Stäben dem in den kundenspezifischen Konfigurierungsdaten festgelegten Auflageabstand angepasst werden. Anstelle einer Verschiebung von Knoten, können beispielsweise auch weitere Felder definierter Struktur am horizontalen Schenkel einer Knicksektion oder beiden Knicksektionen angefügt werden.

Mit anderen Worten werden an dem mit Feldern überlagerten, zweidimensionalen Layout Auflagestellen in den Bereichen der beiden Umlenkbereiche vorgesehen. Sofern nach der Überlagerung der Felder ein Auflageabstand der Auflagestellen nicht einem geforderten Auflageabstand der kundenspezifischen Konfigurierungsdaten entspricht, wird der Auflageabstand durch Einfügen eines weiteren Feldes oder durch eine Verlängerung eines Feldes im Bereich mindestens eines der beiden Umlenkbereiche vergrössert.

Gegebenenfalls ist der Auflageabstand zwischen den Auflagestellen so lang, dass eine im Regelsatz hinterlegte Sektionslänge überschritten wird. Diese Sektionslänge berücksichtigt beispielsweise fertigungstechnische Grenzen wie eine maximal zur Verfügung stehende Länge von Stahlprofilen oder transporttechnische Grenzen wie die nutzbare Länge eines nach internationalem Standard ISO 668 gefertigten Transportcontainers. Bei einer Überschreitung der Sektionslänge werden durch den Regelsatz so viele Trennstellen eingefügt, dass keine der Sektionen die maximale Sektionslänge überschreitet. Hierbei kann die Aufteilung in gleich lange Sektionen erfolgen. Dies ist aber nicht zwingend. Gegebenenfalls kann sich die Aufteilung auch nach der maximalen Länge von Stahlprofilen oder der nutzbaren Transportlänge richten.

Sofern vom Regelsatz eine Trennstelle vorgesehen ist, wird dort vom Regelsatz automatisch eine an der Trennstelle und am Führungsweg ausgerichtete Trennsektion eingefügt. Eine Trennsektion ist hierbei ein vordefiniertes Feld, welches vorzugsweise orthogonal zum Führungsweg in einer Trennstelle zweigeteilt ist.

Das wie vorangehend beschrieben, teilweise durch Felder überlagerte, zweidimensionale Layout weist nun noch Lücken zwischen den Feldern auf, die durch den Regelsatz möglichst mit Standardfeldern überlagert werden, wobei der Regelsatz die Standardfelder am Führungsweg ausgerichtet, in den Lücken aneinanderreiht. Standardfelder sind Felder gleicher Länge und gleicher Struktur beziehungsweise gleicher Anordnung von Knoten und Stäben. Es wäre aber reiner Zufall, wenn die Lücken vollständig mit Standardfeldern überlagert werden könnten. Im Regelfall bleibt eine Rest-Lücke, die kürzer als ein Standardfeld ist. Der Regelsatz passt in jede dieser Lücken ein am Führungsweg ausgerichtetes Ausgleichsfeld ein. Dessen Struktur aus Knoten und Stäben gleicht derjenigen eines Standardfeldes, ist aber kürzer als das Standardfeld.

Allerdings kann die Rest-Lücke so schmal sein, dass kein vernünftig dimensioniertes Ausgleichsfeld eingepasst werden kann. Für diesen Fall umfasst der Regelsatz eine Überprüfungsroutine, mit der eine minimale Länge eines Ausgleichsfeldes überprüft werden kann. Bei einer Unterschreitung von dessen minimaler Länge kann der Regelsatz ein angrenzendes Standardfeld oder eine Hälfte einer Trennsektion mit dem zu kurz geratenen Ausgleichsfeld verbinden und anschliessend dieses verbundene Feld in zwei gleich lange Ausgleichsfelder unterteilen.

Gegebenenfalls kann es aufgrund der Ausgestaltung des Bauwerkes erforderlich sein, dass mindestens eine Trennstelle durch eine manuelle Eingabe oder aufgrund der kundenspezifischen Konfigurierungsdaten definiert wird. Vorzugsweise überprüft hierbei der Regelsatz, ob die gewählten Trennstellen zu Sektionen führen, welche die im Regelsatz hinterlegte Sektionslänge überschreiten. Bei der Einführung einer Trennstelle kann beispielsweise ein Standardfeld oder ein Ausgleichsfeld durch eine längengleiche Trennsektion ersetzt werden.

Nachdem das zweidimensionale, angepasste Layout vollständig mit Feldern definierter Struktur überlagert und gegebenenfalls durch Hinzufügen von weiteren Feldern auf den erforderlichen Abstand der Auflagestellen gebracht worden ist, sind alle geometrischen Verhältnisse bekannt. Diese dienen dazu, die Stabkräfte in den Stäben der einzelnen Felder mittels des Regelsatzes zu berechnen. Hierzu können beispielsweise aus der Stufenbreite und der Förderhöhe die maximal zu befördernde, auf das Fachwerk wirkende Last sowie die auf das Fachwerk wirkenden, maximalen Bremskräfte und Momente berechnet werden.

Anhand der Stabkräfte kann eine typenspezifische Auswahl von Profilstab-Datensätzen für dreidimensionale Fachwerkmodell-Abschnitte erfolgen, deren Profilstab-Datensätze den Stäben der Felder entsprechend angeordnet sind und aus denen der zu erstellende Fachwerk-Datensatz anhand des durch Felder überlagerten, zweidimensionalen Layouts zusammengesetzt wird.

Anschliessend können im dreidimensionalen Raum zur darin angeordneten Ebene des zweidimensionalen Layouts zwei parallele Ebenen definiert werden, auf denen jeweils der Struktur der Felder entsprechend, aus Profilstab-Datensätzen gebildete, dreidimensionale Fachwerkmodell-Abschnitte entlang des zweidimensionalen Layouts aneinandergefügt werden. Hierbei kann ein dreidimensionaler Fachwerkmodell-Abschnitt Datensätze eines Obergurt-Abschnitts, eines Untergurt-Abschnitts mindestens eines Stehers und mindestens einer Diagonalstrebe aufweisen, deren graphische Repräsentationen gemäss der Struktur der Felder, im dreidimensionalen Raum zueinander angeordnet sind.

Durch das Aneinanderfügen der Fachwerkmodell-Abschnitte werden im dreidimensionalen Raum zwei zueinander parallel angeordnete, dreidimensionale Fachwerkmodell-Seitenteile gebildet. Aus der Stufenbreite kann mittels des Regelsatzes der typenspezifische Abstand dieser parallelen Ebenen beziehungsweise der dreidimensionalen Fachwerkmodell-Seitenteile zueinander, errechnet werden. Die Fachwerkmodell-Seitenteile sind im dreidimensionalen Raum angeordnete, dreidimensionale graphische Repräsentationen und sind als Fachwerkseitenteil-Datensätze im Computersystem speicherbar.

Anschliessend können die zueinander parallel angeordneten Fachwerkseitenteil-Datensätze orthogonal zu deren Ebenen mittels Datensätzen von Querstreben, Bodenquerstreben, Boden-Diagonalstreben und Stirnseitenteilen mit Auflagewinkeln zum Fachwerk-Datensatz ergänzt werden, dessen graphische Repräsentation ein dreidimensionales Fachwerkmodell ist. Hierzu sind im Regelsatz typenspezifische Schnittstellendefinitionen hinterlegt, an welchen Positionen der Fachwerkmodell-Seitenteile beziehungsweise in den Fachwerkseitenteil-Datensätzen die Datensätze von Querstreben, Bodenquerstreben, Boden-Diagonalstreben und Stirnseitenteilen angeordnet werden müssen.

Wie vorangehend erläutert, werden die Fachwerkmodell-Seitenteile durch ein Aneinanderfügen von den Feldern entsprechenden Fachwerkmodell-Abschnitten gebildet. Zur Optimierung einer zukünftigen Fertigung können nun mittels des Regelsatzes aus den durch die Fachwerkmodell-Abschnitte definierten Obergurt-Abschnitte der Fachwerkmodell-Seitenteile ein oder mehrere durchgehende Obergurt-Datensätze erzeugt werden, die die Obergurt-Abschnitte im Fachwerkdatensatz ersetzen. Die Enden der durchgehenden Obergurt-Datensätze können durch die folgenden Strukturmerkmale von Feldern definiert werden: eine Trennstelle der Trennsektion, eine Auflagestelle, eine Knickstelle der oberen oder unteren Knicksektion.

Gattungsgemäss können auch die Untergurt-Abschnitte der Fachwerkmodell-Seitenteile in ein oder mehrere durchgehende Untergurt-Datensätze zusammengefasst werden.

In einer weiteren Ausgestaltung der Erfindung können mittels des Regelsatzes anhand der errechneten Stabkräfte und der geometrischen Daten der entsprechenden

Fachwerkmodell-Abschnitte die erforderlichen, vorzusehenden Schweissnahtlängen in den einzelnen Knoten beziehungsweise Verbindungstellen berechnet werden. Selbstverständlich können auch andere Verbindungsarten berechnet werden, beispielsweise die Anzahl und der Durchmesser von Schrauben, Nieten oder Clinchstellen, wenn in den Knoten Schraubverbindungen, Clinchverbindungen oder Nietverbindungen zur Verbindung der Profilstäbe vorgesehen sind.

Mittels des Regelsatzes kann auch die erforderliche Schweissnahtlänge von sich überlappenden, Verbindungsstellen bildenden Profilstab-Datensätzen eines Knotens mit den in diesem Knoten vorhandenen geometrischen Verhältnissen verglichen werden. Bei zu kurzen Verbindungsstellen kann für den jeweiligen Knoten ein Knotenblech beziehungsweise Knotenblech-Datensatz vorgesehen werden.

Gegebenenfalls können anschliessend die mechanischen Eigenschaften des Fachwerk-Datensatzes als Gesamtheit mittels statischer und/oder dynamischer Simulationen überprüft werden. Eine dieser dynamischen Simulationen kann beispielsweise ein simuliertes Bremsverhalten bei einer Fahrtreppe sein. Hierbei werden von der Nenngeschwindigkeit bis zum Stillstand alle auf das Fachwerk einwirkenden Kräfte sowie die von der Antriebsmaschine abhängigen Kräfte simuliert. Mit diesen Simulationen können festigkeitskritische Stellen überprüft, sowie die auf die einzelnen Profilstäbe beziehungsweise Profilstab-Datensätze einwirkenden dynamischen Kräfte während des Bremsens ermittelt werden. Insbesondere können bei diesen Simulationen auch die statischen und dynamischen Eigenschaften des Fachwerk-Datensatzes während eines Erdbebens mit angenommener Erdbebenstärke und Bauwerkbewegungen simuliert und überprüft und gegebenenfalls Profilstab-Datensätze verändert und/oder weitere Datensätze von Adapterbauteilen zur Verstärkung von dessen Struktur generiert werden.

Mit anderen Worten können zum Erstellen des Fachwerk-Datensatzes, welcher unter Berücksichtigung der kundenspezifischen Konfigurierungsdaten erstellt wurde, Simulationen durchgeführt werden, mit denen statische und/oder dynamische Eigenschaften des kommissionierten Fachwerkes mit dem Computersystem simuliert werden, bevor ein entsprechendes, physisches Fachwerk hergestellt wird.

Statische Simulationen analysieren hierbei beispielsweise ein statisches Zusammenwirken mehrerer Profilstäbe. Mithilfe statischer Simulationen kann beispielsweise analysiert werden, ob es beim Zusammenbau von mehreren Profilstäben bei ungünstiger Summierung von Fertigungstoleranzen zu Problemen kommen kann.

Der Regelsatz kann des Weiteren produktionsspezifische Daten enthalten und diese mit dem dreidimensionalen Fachwerk-Datensatz verbinden. Die produktionsspezifischen Daten beziehen sich typischerweise auf Eigenschaften oder Vorgaben innerhalb einer Fertigungsfabrik oder Fertigungslinie, in der das Fachwerk gefertigt werden soll.

Beispielsweise können je nachdem in welchem Land oder an welchem Ort eine Fertigungsfabrik steht, in der Fertigungsfabrik verschiedene Bedingungen herrschen und/oder Vorgaben einzuhalten sein. Beispielsweise können in manchen Fertigungsfabriken bestimmte Materialien, Rohstoffe, Rohbauteile oder Ähnliches nicht verfügbar sein oder nicht verarbeitet werden. In manchen Fertigungsfabriken können Maschinen eingesetzt werden, die in anderen Fertigungsfabriken fehlen. Manche Fertigungsfabriken unterliegen aufgrund ihrer Auslegung Restriktionen hinsichtlich der darin zu fertigenden Personentransportanlagen bzw. Komponenten derselben. Manche Fertigungsfabriken ermöglichen einen hohen Grad an automatisierter Fertigung, wohingegen andere Fertigungsfabriken beispielsweise aufgrund niedriger Lohnkosten eher manuelle Fertigung einsetzen können. Es können noch eine Vielzahl weiterer Bedingungen und/oder Vorgaben existieren, bezüglich derer sich Fertigungsumgebungen unterscheiden können. All diese produktionsspezifischen Daten müssen typischerweise beim Planen bzw. Kommissionieren eines Fachwerkes und schlussendlich auch bei der gesamten Fahrtreppe oder des gesamten Fahrsteiges berücksichtigt werden, da von ihnen abhängig sein kann, in welcher Weise diese tatsächlich gebaut werden können.

Konkrete Ausgestaltungen des Verfahrens zur Erstellung eines dreidimensionalen Fachwerk-Datensatzes einer Fahrtreppe oder eines Fahrsteiges werden weiter unten mit Bezug auf bevorzugten Ausführungsformen dargelegt.

Ausführungsformen des hierin vorgestellten Verfahrens können mithilfe eines hierfür speziell konfigurierten Computersystems durchgeführt werden. Das Computersystem kann einen oder mehrere Computer umfassen. Insbesondere kann das Computersystem aus einem Computernetzwerk gebildet sein, welches Daten in Form einer Datenwolke (Cloud) verarbeitet. Das Computersystem kann hierfür über einen Speicher verfügen, in dem die Daten des Fachwerk-Datensatzes, der Steher-, Querstreben-, Obergurt-, Untergurt-, Diagonalstreben-, Bodenquerstreben-, und Diagonalbodenstreben-Datensätze, Daten des Regelsatzes, bis hin zu produktionsspezifischen Daten gespeichert werden können, beispielsweise in elektronischer oder magnetischer Form. Das Computersystem kann ferner über Datenverarbeitungsmöglichkeiten verfügen. Beispielsweise kann das Computersystem einen Prozessor aufweisen, mithilfe dessen Daten all dieser Datensätze und des Regelsatzes verarbeitet werden können. Das Computersystem kann ferner über Schnittstellen verfügen, über die Daten in das Computersystem eingegeben und/oder aus dem Computersystem ausgegeben werden können, das Computersystem kann auch räumlich verteilt implementiert sein, beispielsweise wenn Daten über mehrere Computer verteilt in einer Datenwolke verarbeitet werden.

Insbesondere kann das Computersystem programmierbar sein, das heißt durch ein geeignet programmiertes Computerprogrammprodukt dazu veranlasst werden, Computerverarbeitbare Schritte und Daten des erfindungsgemäßen Verfahrens auszuführen oder zu steuern. Das Computerprogrammprodukt kann Anweisungen oder Code enthalten, welche beispielsweise den Prozessor der Vorrichtung dazu veranlassen, Daten des Fachwerk-Datensatzes zu erstellen, abzuspeichern, auszulesen, zu verarbeiten, zu modifizieren, etc. Das Computerprogrammprodukt kann in einer beliebigen Computersprache verfasst sein.

Das Computerprogrammprodukt kann auf einen beliebigen computerlesbaren Medium gespeichert sein, beispielsweise einem Flash-Speicher, einer CD, einer DVD, RAM, ROM, PROM, EPROM, einer Diskette und dergleichen mehr. Das Computerprogrammprodukt und/oder die damit zu verarbeitenden Daten können auch auf einem Server oder mehreren Servern gespeichert sein, beispielsweise in einer Datenwolke, von wo aus sie über ein Netz, beispielsweise das Internet, heruntergeladen werden können.

Abschließend wird daraufhingewiesen, dass einige der möglichen Merkmale und Vorteile der Erfindung hierin mit Bezug auf unterschiedliche Ausführungsformen beschrieben sind. Ein Fachmann erkennt, dass die Merkmale in geeigneter Weise kombiniert, übertragen, angepasst oder ausgetauscht werden können, um zu weiteren Ausführungsformen der Erfindung zu gelangen.

Nachfolgend werden Ausführungsformen der Erfindung unter Bezugnahme auf die beigefügten Zeichnungen beschrieben, wobei weder die Zeichnungen noch die Beschreibung als die Erfindung einschränkend auszulegen sind.
Figur 1 veranschaulicht anhand eines Blockdiagramms die Verfahrensschritte des erfindungsgemäßen Verfahrens zur Erstellung eines Fachwerk-Datensatzes sowie die zur Durchführung erforderlichen Interaktionen in Bezug auf die das Verfahren begleitenden Datensätze.
Figur 2 zeigt in dreidimensionaler Ansicht ein typenspezifisches, zweidimensionales Layout.
Figur 3 zeigt in dreidimensionaler Ansicht das in einer spezifizierten Förderhöhe angepasste typenspezifische, zweidimensionale Layout.
Figur 4 zeigt in dreidimensionaler Ansicht die Unterteilung des in der Förderhöhe angepassten, zweidimensionale Layouts.
Figur 5 zeigt in dreidimensionaler Ansicht die Überlagerung des in der Förderhöhe angepassten, zweidimensionale Layouts mit einem ersten, eine Knicksektion definierenden Feld vordefinierter Struktur.
Figur 6 zeigt in dreidimensionaler Ansicht die Überlagerung weiterer, an die Knicksektionen anschliessender Felder definierter Struktur, um das zweidimensionale Layout an den in den kundenspezifischen Konfigurierungsdaten definierten Abstand der Auflagestellen anzupassen.
Figur 7 zeigt in dreidimensionaler Ansicht die Überlagerung des in der Förderhöhe angepassten, zweidimensionale Layouts mit einem ersten, eine Trennsektion definierenden Feld vordefinierter Struktur.
Figur 8 zeigt in dreidimensionaler Ansicht das vollständig mit Feldern definierter Struktur überlagerte, in der Förderhöhe angepasste, zweidimensionale Layout.
Figur 9 zeigt in dreidimensionaler Ansicht den beginnenden Aufbau von zwei Fachwerkmodell-Seitenteilen mit dreidimensionalen Fachwerkmodell-Abschnitten beziehungsweise Profil-Datensätzen in zwei zum zweidimensionalen Layout parallelen Ebenen.
Figur 10 zeigt den in der Figur 9 dargestellten Fachwerkmodell-Abschnitt sowie eine an diesen anschliessenden Fachwerkmodell-Abschnitt einer Knicksektion in vergrösserter Darstellung.

Die Figuren sind lediglich schematisch und nicht maßstabsgetreu. Gleiche Bezugszeichen bezeichnen in den verschiedenen Figuren gleiche oder gleichwirkende Merkmale.

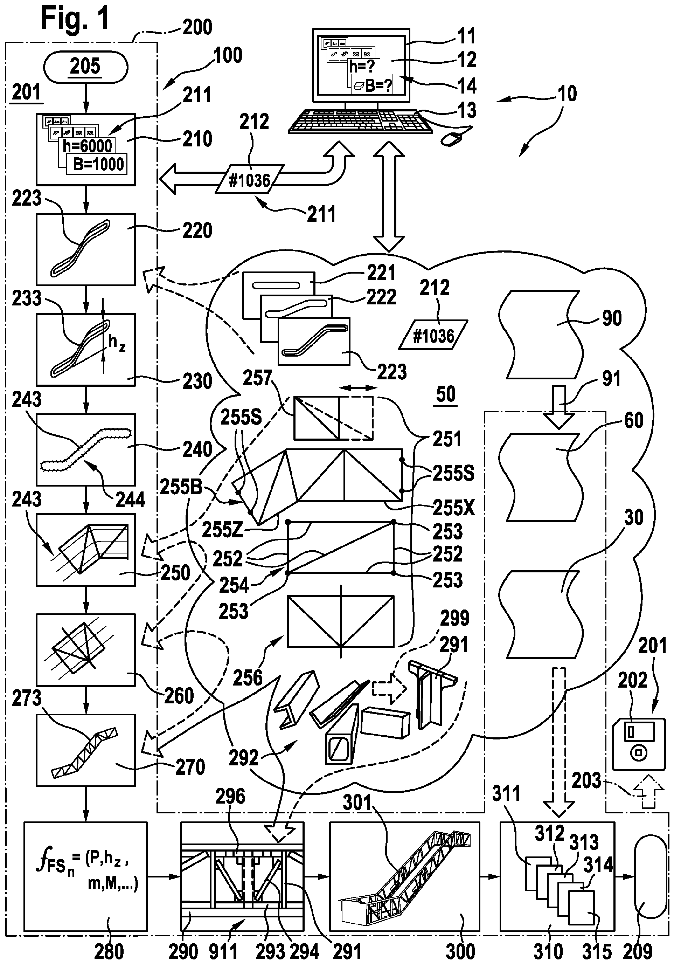

In der Figur 1 sind anhand eines Blockdiagramms 100 die wesentlichen Verfahrensschritte 210 bis 310 des erfindungsgemäßen Verfahrens 200 zur Erstellung eines dreidimensionalen Fachwerk-Datensatzes 301 einer Fahrtreppe oder eines Fahrsteiges dargestellt. Der besseren Übersicht wegen sind die wesentlichsten Verfahrensteile des Verfahrens 200 durch eine strichpunktierte Linie umrandet. Die Verfahrensschritte 210 bis 310 des vorliegenden Verfahrens 200 sind Teil eines Computerprogramms 201, das in einem Computersystem 10 ausgeführt werden kann. Das Computersystem 10 kann einen oder mehrere Computer 11 umfassen. Insbesondere kann das Computersystem 10 aus einem Computernetzwerk gebildet sein, welches Daten in Form einer Datenwolke 50 (Cloud) verarbeitet. Das Computersystem 10 kann hierfür über einen Speicher verfügen, in dem die Daten des Fachwerk-Datensatzes 301, aber auch weitere wie beispielsweise, Profilstab-Datensätze 292, Querstreben-, Obergurt-, Untergurt-, Diagonalstreben-, Diagonalbodenstreben-, Bodenquerstreben- und Steher-Datensätze 291, Daten eines Regelsatzes 60, bis hin zu produktionsspezifischen Daten 30 gespeichert werden können, beispielsweise in elektronischer oder magnetischer Form. Das Computersystem 10 kann ferner über Datenverarbeitungsmöglichkeiten verfügen. Beispielsweise kann das Computersystem 10 einen Prozessor aufweisen, mithilfe dessen Daten all dieser Datensätze und des Regelsatzes 60 verarbeitet werden können. Das Computersystem 10 kann ferner über Schnittstellen 12, 13 verfügen, über die beispielsweise durch manuelle Eingaben Daten in das Computersystem 10 eingegeben und/oder aus dem Computersystem 10 ausgegeben werden können. das Computersystem 10 kann auch räumlich verteilt implementiert sein, beispielsweise wenn Daten über mehrere Computer 11 verteilt in einer Datenwolke 50 verarbeitet werden.

Insbesondere kann das Computersystem 10 programmierbar sein, das heißt durch das geeignet programmierte Computerprogramm 201 beziehungsweise Computerprogrammprodukt dazu veranlasst werden, Computer- verarbeitbare Schritte und Daten des erfindungsgemäßen Verfahrens 200 auszuführen oder zu steuern. Das Computerprogramm 201 kann Anweisungen oder Code enthalten, welche beispielsweise den Prozessor des Computersystems 10 dazu veranlassen, Daten des Fachwerk-Datensatzes 301 zu erstellen, abzuspeichern, auszulesen, zu verarbeiten, zu modifizieren, etc. Das Computerprogramm 201 kann in einer beliebigen Computersprache verfasst sein.

Das Computerprogramm 201 kann, wie durch den strichpunktierten Pfeil 203 symbolisch dargestellt als Computerprogrammprodukt auf einem beliebigen computerlesbaren Medium 202 gespeichert sein, beispielsweise einem Flash-Speicher, einer Diskette, einer CD, einer DVD, RAM, ROM, PROM, EPROM, und dergleichen mehr. Das Computerprogramm 201 und/oder die damit zu verarbeitenden Daten können auch auf einem Server oder mehreren Servern gespeichert sein, beispielsweise in der Datenwolke 50, von wo aus sie über ein Netz, beispielsweise das Internet, heruntergeladen werden können.

Mittels des Computerprogramms 201 können die Verfahrensschritte 210 bis 310 ausgeführt werden, wobei diese gemäss der dargestellten Reihenfolge, aber nicht zwingenderweise in dieser Reihenfolge, abgearbeitet werden können. Insbesondere besteht auch die Möglichkeit, gewisse Verfahrensschritte 210 bis 310 wie beispielsweise die Verfahrensschritte des Überlagerns von Feldern definierter Struktur in einem Überlagerungs-Verfahrensschritt 250 und das Einfügen von Trennsektionen in einem Trennsektions-Verfahrensschritt 260 parallel durchzuführen, sofern die Rechenleistung des Computersystems 10 dies zulässt. Zudem können bei einigen Verfahrensschritten 210 bis 310 übergreifende iterative Schlaufen erforderlich sein, insbesondere wenn es um statische und dynamische Berechnungen geht, die der besseren Übersicht wegen symbolisch in einem Berechnungs-Verfahrensschritt 280 zusammengefasst sind. Ausgehend vom Programmstart 205, werden in einem Konfigurierungs-Verfahrensschritt 210 kundenspezifische Konfigurierungsdaten 211 ermittelt, die Angaben zumindest zur Stufenbreite B und zur Förderhöhe hz beinhalten. Hierzu kann das Computerprogramm 201 Schritte durchführen, die auf einem Bildschirm 12 Eingabemasken 14 mit Eingabefelder erzeugen und gegebenenfalls die vom Kunden gewünschte Stufenbreite B und Förderhöhe h_{Z} direkt abfragen. Selbstverständlich ist auch eine Abfrage anderer kundenspezifischer Konfigurierungsdaten 211 möglich, aus denen sich durch geeignete Programmroutinen die Stufenbreite B und die Förderhöhe hz ermitteln lässt.

Gegebenenfalls kann vom Computerprogramm 201 auch auf ein vom Kunden zur Verfügung gestelltes Logfile 212 zugegriffen werden, um entsprechende Daten aus diesem Logfile 212 zu extrahieren. Ein solches Logfile 212 kann beispielsweise vom Kunden mittels eines Programms erzeugt werden, welches ihm ein sogenanntes BIM-Modell (Building Information Model) zur Verfügung stellt. Solche BIM-Modelle sind digitale, dreidimensionale Hüllenmodelle von Fahrtreppen oder Fahrsteigen, die durch den Kunden mittels Eingaben konfiguriert werden und die er hernach in sein digitales, dreidimensionales Gebäudemodell einfügen kann.

In einem Layout-Verfahrensschritt 220 kann aufgrund der kundenspezifischen Konfigurierungsdaten 211 vom Computerprogramm 201 ein typenspezifisches, zweidimensionales Layout 221, 222, 223 vorgeschlagen werden. Selbstverständlich kann ein typenspezifisches, zweidimensionales Layout 221, 222, 223 auch mittels einer Eingabe durch den Benutzer gewählt werden.

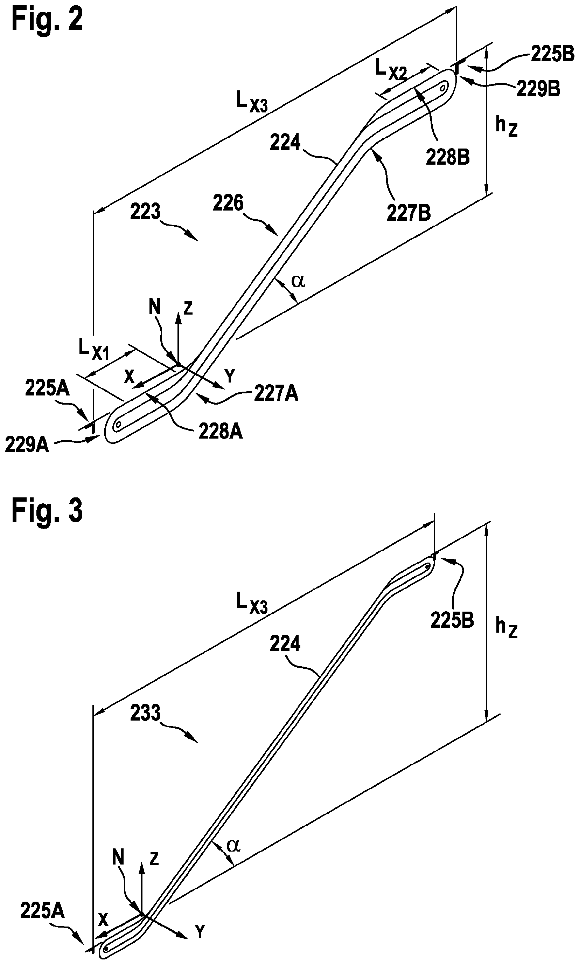

Typenspezifische, zweidimensionale Layouts 221, 222, 223 geben den produktspezifischen Charakter einer Produktereihe wieder. Das bedeutet, dass insbesondere daraus ersichtlich ist, ob es ein zweidimensionales Layout eines horizontalen Fahrsteiges 221, ein zweidimensionales Layout eines schrägen Fahrsteiges 222 oder ein zweidimensionales Layout einer Fahrtreppe 223 ist. Selbstverständlich können von jedem dieser «Grundlayouts» noch weitere Layouts vorhanden sein, insbesondere können von einer Fahrtreppe je nach Anzahl der verschiedenen Produkte eine entsprechende Anzahl von zweidimensionalen Layouts vorhanden sein. Als Beispiel hierfür können zwei Fahrtreppentypen mit unterschiedlichen Neigungswinkeln des Mittelteiles dienen, wobei für jeden dieser beiden Fahrtreppentypen ein zweidimensionales Layout verfügbar ist. Im vorliegenden Ausführungsbeispiel der Figur 1 wurde das zweidimensionale Layout einer Fahrtreppe 223 ausgewählt. Weiterführende Erklärungen zu den zweidimensionalen Layouts 221, 222, 223 erfolgen weiter unten in der Beschreibung zur Figur 2 ebenfalls anhand des zweidimensionalen Layouts einer Fahrtreppe 223.

Das ausgewählte, zweidimensionales Layout 221, 222, 223 ist lediglich eine Vorlage, die an die kundenspezifischen Konfigurierungsdaten 211, insbesondere an die Förderhöhe hz angepasst werden muss. Dieser Anpassungs-Verfahrensschritt 230 führt zum angepassten, zweidimensionales Layout 233. Weiterführende Erklärungen zur Anpassung des in der Figur 2 dargestellten, ausgewählten zweidimensionalen Layouts 223 hin zum angepassten zweidimensionalen Layout 233 erfolgen weiter unten in der Beschreibung zur Figur 3.

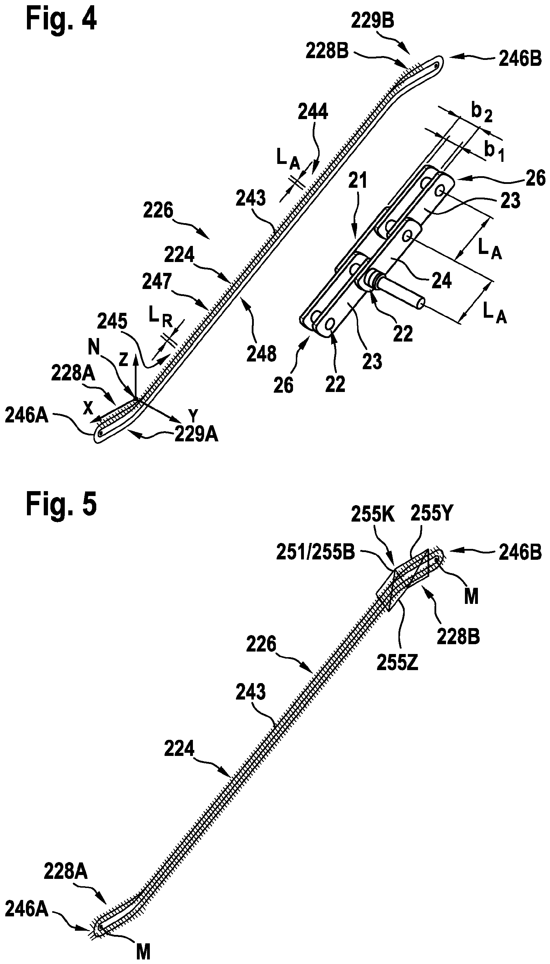

In einer Initialerfassung 240 wird der Führungsweg des im vorangehenden Verfahrensschritt in der Förderhöhe angepassten Layouts 233 in Teilungsabschnitte 244 unterteilt. Sinn und Zweck dieser Unterteilung besteht darin, dass das aufgrund des Fachwerk-Datensatzes 301 später hergestellte, physische Fachwerk ausreichend Raum zur Aufnahme eines Stufenbandes beziehungsweise seiner umlaufenden Förderketten 21 (siehe Figur 4) bietet. Weiterführende Erklärungen zur Unterteilung des in der Figur 3 angepassten zweidimensionalen Layouts 233 hin zum unterteilten, zweidimensionalen Layout 243 mit unterteiltem Führungsweg erfolgen weiter unten in der Beschreibung zur Figur 4.

In einem Überlagerungs-Verfahrensschritt 250 können nun dem unterteilten, zweidimensionalen Layout 243 mittels des Regelsatzes 60, Felder 251 vordefinierter Struktur überlagert werden. Auch diese Felder 251 sind zweidimensionale Vorlagen, die in fachwerktypischer Anordnung Stäbe 252 und Knoten 253 (Bezugszeichen nur beim Standardfeld 254 angegeben) umfassen. Das heisst, dass jedes dieser Felder 251 einem Schnittmuster gleich, die Lage der weiter unten beschriebenen Profilstab-Datensätze 292, Querstreben-, Obergurt-, Untergurt-, Diagonalstreben-, Diagonalbodenstreben-, Bodenquerstreben- und Steher-Datensätze 291 in der Ebene vorgeben. Weiterführende Erklärungen zum Überlagerungs-Verfahrensschritt 250 erfolgen in der Beschreibung zu den Figuren 5 bis 8.

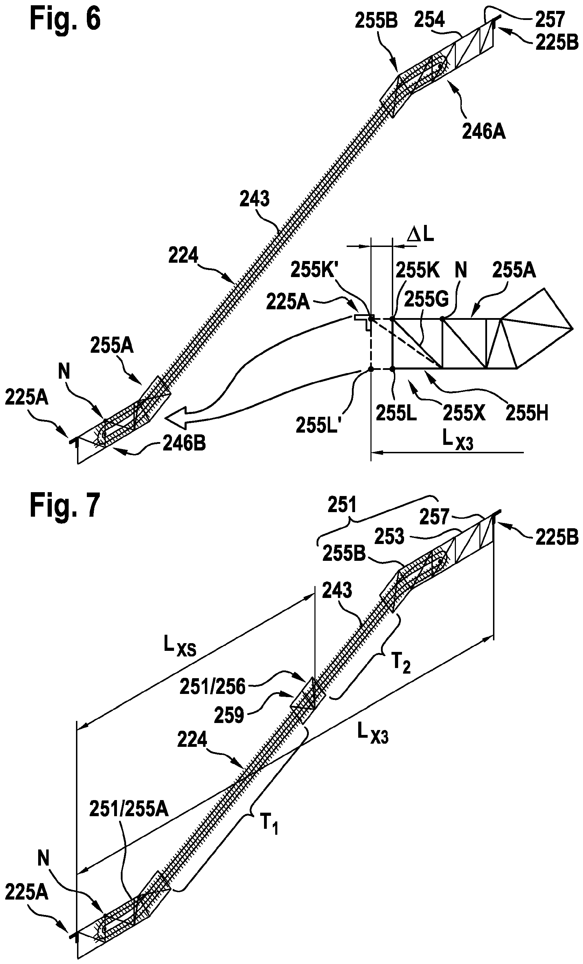

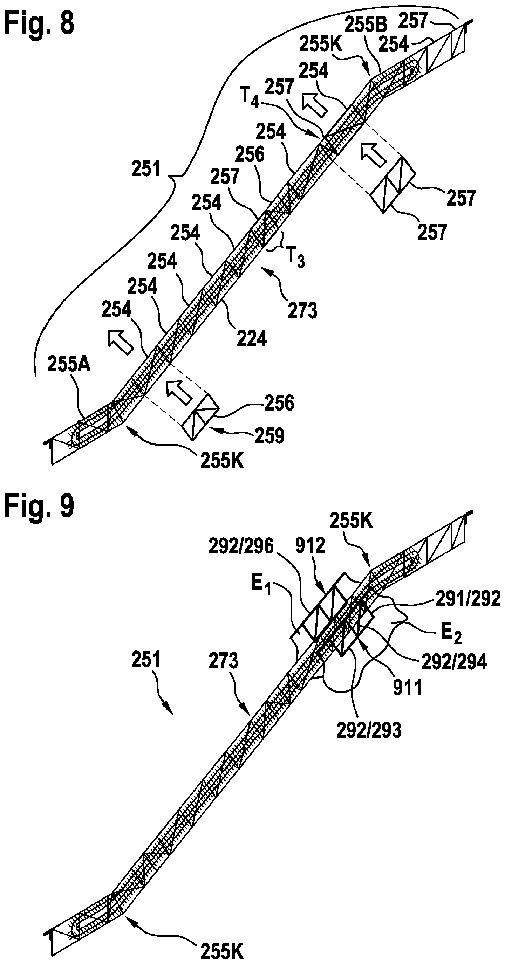

Gegebenenfalls kann es aufgrund der Ausgestaltung des Bauwerkes oder der vorhandenen Transportkapazität erforderlich sein, dass mindestens eine Trennsektion 256 durch eine manuelle Eingabe oder aufgrund der kundenspezifischen Konfigurierungsdaten 211 in einem Trennstellen-Verfahrensschritt 260 definiert wird. Weiterführende Erklärungen zum Trennstellen-Verfahrensschritt 260 erfolgen weiter unten in der Beschreibung zu den Figuren 7 und 8.

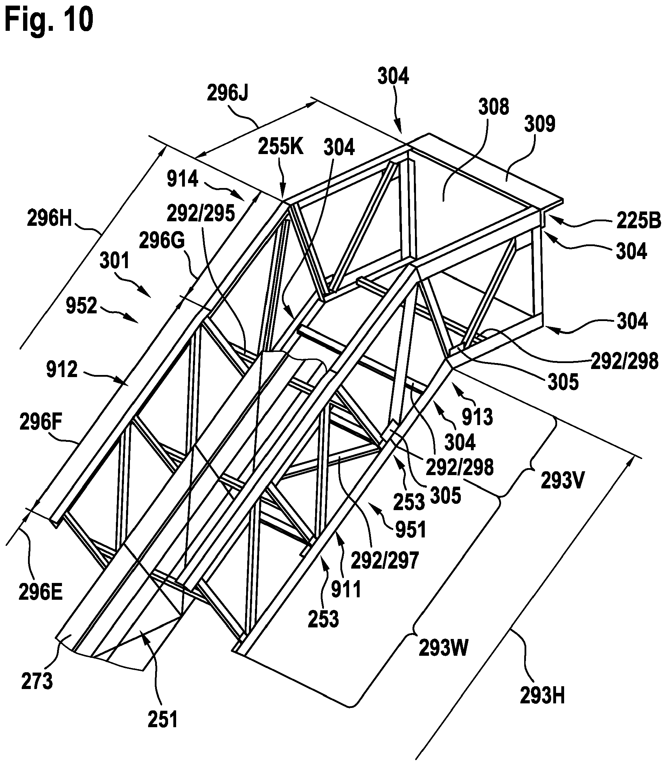

Nachdem dem zweidimensionalen, unterteilten Layout 243 die speziell ausgestalteten Felder 251 definierter Struktur wie beispielsweise Knicksektionen 255A, 255B und die Trennsektionen 256 überlagert worden sind, werden nun in einem Komplettierungs-Verfahrensschritt 270 die noch nicht überlagerten Bereiche des Layouts 243 vollständig mit Feldern 251 definierter Struktur, insbesondere mit Standardfeldern 254 und Ausgleichsfeldern 257 überlagert. Das dadurch geschaffene, überlagerte zweidimensionale Layout 273 weist nun alle geometrischen Verhältnisse in der Ebene eines Fachwerk-Seitenteiles auf, welches in den Figuren 9 und 10 näher beschrieben wird. Weiterführende Erklärungen zum Komplettierungs-Verfahrensschritt 270 erfolgen weiter unten in der Beschreibung insbesondere zu den Figuren 7 und 8.

Die durch die Felder definierten, geometrischen Verhältnisse dienen dazu, in einem Berechnungs-Verfahrensschritt 280 die Stabkräfte F_{Sn} in den Stäben der einzelnen Felder 251 mittels des Regelsatzes 60 zu berechnen. Hierzu können beispielsweise aus der Stufenbreite B und der Förderhöhe hz, ergänzt durch weitere Daten beispielsweise aus Normwerken 90 die maximal zu befördernde, auf das Fachwerk beziehungsweise dessen Fachwerk-Datensatz 301 wirkende Masse m sowie die auf das Fachwerk wirkenden, maximalen Bremskräfte P und Momente M berechnet werden. Mit den bekannten Berechnungsverfahren aus der technischen Mechanik und der Festigkeitslehre oder mit Finite-Elemente-Berechnungsprogrammen können nun die einzelnen Stabkräfte F_{Sn} gemäss ihrer geometrischen Anordnung in den Feldern 251 berechnet werden.

Im Selektierungs-Verfahrensschritt 290 kann Anhand der Stabkräfte F_{Sn} eine typenspezifische Auswahl von Profilstab-Datensätzen 292 erfolgen, insbesondere für Steher-Datensätze 291, Obergurt-Datensätze 296, Untergurt- Datensätze 293, Diagonalstreben- Datensätze 294, Querstreben-Datensätze, Bodenquerstreben-Datensätze, Diagonalbodenstreben- Datensätze und Knotenblech-Datensätze. Wie durch den Pfeil 299 angedeutet, werden die Steher-Datensätze 291 auch aus Profilstab-Datensätzen 292 zusammengesetzt. Aus diesen werden wie in den Figuren 9 und 10 dargestellt, Fachwerkmodell-Abschnitte 911, 912 913, 914 generiert, deren Profilstab-Datensätze 292 den Stäben der Felder 251 entsprechend angeordnet und in den Knoten 253 miteinander verbunden sind und aus denen der zu erstellende Fachwerk-Datensatz 301 anhand des durch Felder 251 überlagerten zweidimensionalen Layouts 273 zusammengesetzt wird. Auch die in den Knoten 253 vorzusehenden Verbindungsmittel wie Schweissnähte, Nieten, Passschrauben, Clinchstellen und dergleichen mehr werden auf Basis der einzelnen Stabkräfte F_{Sn} berechnet und festgelegt.

Da die Auswahl auch von geltenden Normenwerken 90 wie beispielsweise die EN115-1 beeinflusst wird, wirken diese, symbolisch durch den Pfeil 91 dargestellt, auch auf den Regelsatz 60 ein. Weiterführende Erklärungen zum Selektions-Verfahrensschritt 270 erfolgen weiter unten in der Beschreibung insbesondere zu den Figuren 9 und 10.

Sobald wie im Komplettierungs-Verfahrensschritt 300 dargestellt, der Fachwerk-Datensatz 301 aus den Fachwerkmodell-Abschnitten und weiteren Profilstab-Datensätzen 292 zusammengesetzt ist, können gegebenenfalls die mechanischen Eigenschaften des Fachwerk-Datensatzes 301 als Gesamtes beispielsweise durch den Regelsatz 60 mittels statischer und/oder dynamischer Simulationen überprüft werden.

Statische Simulationen analysieren hierbei beispielsweise ein statisches Zusammenwirken mehrerer Profilstab-Datensätze 292. Mithilfe statischer Simulationen kann beispielsweise analysiert werden, ob es beim Zusammenbau von mehreren Profilstäben bei ungünstiger Summierung von Fertigungstoleranzen zu Problemen kommen kann.

Eine der dynamischen Simulationen kann beispielsweise ein simuliertes Bremsverhalten bei einer voll beladenen Fahrtreppe sein. Hierbei werden von der Nenngeschwindigkeit bis zum Stillstand alle auf das Fachwerk beziehungsweise den diesem zugrundeliegende Fachwerk-Datensatz 301 einwirkenden Kräfte sowie die von der Antriebsmaschine abzustützenden Kräfte simuliert. Gegebenenfalls kann der Fachwerk-Datensatz 301 im Sinne eines In-the-Loop Ansatzes in einen vergleichbaren, bereits existierenden Digitaler-Doppelgänger-Datensatz (Digital Twin) einer existierenden Fahrtreppe eingebunden und mit dessen statischen und dynamischen Kräften und Momenten überprüft und durchgerechnet werden.

Aufgrund dieser Simulationen können festigkeitskritische Stellen lokalisiert, überprüft, sowie die auf die einzelnen Profilstäbe beziehungsweise Profilstab-Datensätze 292 einwirkenden dynamischen Kräfte während des Betriebes, während des Anfahrens und Bremsens und während unüblichen Betriebszuständen ermittelt werden. Insbesondere können die statischen und dynamischen Eigenschaften des Fachwerk-Datensatzes 301 während eines Erdbebens mit angenommener Erdbebenstärke und Bauwerkbewegungen simuliert, überprüft und gegebenenfalls Profilstab-Datensätze 292 verändert und/oder weitere Datensätze von Adapterbauteilen zur Verstärkung der Struktur des fachwerk-Datensatzes 301 generiert werden.

Mit anderen Worten können zum Erstellen des Fachwerk-Datensatzes 301, welcher unter Berücksichtigung der kundenspezifischen Konfigurierungsdaten 211 erstellt wurde, Simulationen durchgeführt werden, mit denen statische und/oder dynamische Eigenschaften des kommissionierten Fachwerkes mit dem Computersystem 10 simuliert werden, bevor ein entsprechendes, physisches Fachwerk hergestellt wird.

Grundsätzlich könnte das erfindungsgemässe Verfahren 211 mit dem Komplettierungs-Verfahrensschritt 300 bereits abgeschlossen werden. Die Berechnungen des Fachwerk-Datensatzes 301 basieren jedoch auf angenommenen Materialdaten. Um einen noch präziseren Fachwerk-Datensatz 301 zu erhalten, kann der Regelsatz 60 auf produktionsspezifische Daten 30 zugreifen oder diese sogar enthalten und in einem Produktionsvorbereitungs-Verfahrensschritt 310 mit dem dreidimensionalen Fachwerk-Datensatz 301 verbinden. Die produktionsspezifischen Daten 30 beziehen sich typischerweise auf Eigenschaften oder Vorgaben innerhalb einer Fertigungsfabrik oder Fertigungslinie, in der das physische Fachwerk auf der Basis des Fachwerk-Datensatzes 301 gefertigt werden soll.

Beispielsweise können je nachdem in welchem Land oder an welchem Ort eine Fertigungsfabrik steht, in der Fertigungsfabrik verschiedene Bedingungen herrschen und/oder Vorgaben einzuhalten sein. Beispielsweise können in manchen Fertigungsfabriken bestimmte Materialien, Rohstoffe, Rohbauteile oder Ähnliches nicht verfügbar sein oder nicht verarbeitet werden. In manchen Fertigungsfabriken können Maschinen eingesetzt werden, die in anderen Fertigungsfabriken fehlen. Manche Fertigungsfabriken unterliegen aufgrund ihrer Auslegung Restriktionen hinsichtlich der darin zu fertigenden Fahrtreppen und Fahrsteige bzw. Komponenten derselben. Manche Fertigungsfabriken ermöglichen einen hohen Grad an automatisierter Fertigung, wohingegen andere Fertigungsfabriken beispielsweise aufgrund niedriger Lohnkosten eher manuelle Fertigung einsetzen können. Es können noch eine Vielzahl weiterer Bedingungen und/oder Vorgaben existieren, bezüglich derer sich Fertigungsumgebungen unterscheiden können. All diese produktionsspezifischen Daten müssen typischerweise beim Planen bzw. Kommissionieren eines Fachwerkes und schlussendlich auch bei der gesamten Fahrtreppe oder des gesamten Fahrsteiges berücksichtigt werden, da von ihnen abhängig sein kann, in welcher Weise das Fachwerk tatsächlich gebaut werden kann.

Bei der Verknüpfung des Fachwerk-Datensatzes 301 mit den produktionsspezifischen Daten 30 können eine Vielzahl von Dokumenten wie Stücklisten 311, Fertigungszeichnungen mit Toleranz- und Fertigungsangaben 312, Fertigungsprogramme für Produktionsmaschinen 313, Daten für Preiskalkulationen 314, Daten für Produktionsplanungssysteme 315 und dergleichen mehr erzeugt werden. Gegebenenfalls können dadurch insbesondere die Materialdaten der einzelnen Profilstab-Datensätze 292 verändert werden. Vorzugsweise werden diese Materialdaten als charakterisierende Eigenschaften auf die betroffenen Profilstab-Datensätze 292 des Fachwerk-Datensatzes 301 übertragen und gegebenenfalls mit diesem präzisierten Fachwerk-Datensatz 301 nochmals statische und dynamische Simulationen durchgeführt.

Mit dem Programmende 209 ist ein kompletter Fachwerk-Datensatz 301 vorhanden, dessen virtuelle Repräsentation ein dreidimensionales Modell des herzustellenden, kommissionierten Fachwerkes ist. Zudem können, falls der Produktionsvorbereitungs-Verfahrensschritt 310 durchgeführt wurde, auch alle produktionsrelevanten Daten und Unterlagen vorhanden sein.

Figur 2 zeigt wie bereits zur Figur 1 erklärt, in dreidimensionaler Ansicht ein typenspezifisches, zweidimensionales Layout einer Fahrtreppe 223. Dieses zweidimensionale Layout 223 weist im Wesentlichen den Führungsweg 224 eines nicht dargestellten Stufenbandes sowie dessen umlaufender Förderkette und einen definierten Nullpunkt N auf. Alle Anpassungen des zweidimensionalen Layouts 223 können beispielsweise ausgehend von diesem Nullpunkt N durchgeführt werden.

Das zweidimensionale Layout 223 ist gewissermassen eine Vorlage, die charakteristisch für einen bestimmten Fahrtreppen- oder Fahrsteigtyp ist. Um den fertigungstechnischen Aufwand zu optimieren, werden Produkte als sogenannte Typen entwickelt. Das bedeutet, dass zum Beispiel ein bestimmter Fahrtreppentyp für Förderhöhen bis sechs Metern ausgelegt ist, während ein anderer Fahrtreppentyp für Förderhöhen bis dreissig Meter ausgelegt ist. Die typenspezifischen, zweidimensionalen Layouts 223 dieser beiden Fahrtreppentypen unterscheiden sich voneinander beispielsweise in der zulässigen Neigung α des Führungsweges 224 im geneigten Abschnitt 226 der Fahrtreppe, in den Übergangsbogen 227A, 227B des Führungsweges 224 und in der Länge Lxi, L_{X2} der horizontalen Abschnitte 228A, 228B des Führungsweges 224. Diese sind in den, zu beiden Enden des geneigten Abschnitts 226 anschliessenden Zutrittsbereichen 229A, 229B angeordnet. Wenn nachfolgend Merkmale als «typenspezifisch» bezeichnet werden, sind diese immer zum entsprechenden, typenspezifischen, zweidimensionalen Layout 223 passend.

Die in der vorliegenden Beschreibung verwendeten Lage-Angaben «horizontal», «vertikal» und «geneigt» beziehen sich immer auf die geplante Einbaulage des zu erstellenden Fachwerkes in einem Bauwerk. Die Indizes der Massangaben richten sich gemäss ihrer Orientierung im dreidimensionalen Raum nach dem für den Nullpunkt N angegebenen, kartesischen Koordinatensystem. Ferner bezieht sich das Merkmal Förderhöhe h_{Z} auf den vertikalen Abstand zwischen den beiden, in den Zutrittsbereichen 229A, 229B angeordneten Auflagestellen 225A, 225B, während das Merkmal Auflageabstand L_{X3} sich auf den horizontalen Abstand zwischen den beiden Auflagestellen 225A, 225B bezieht.

Mit anderen Worten ausgedrückt, ist das zweidimensionale Layout 223 eine Seitenansicht des Führungsweges 224 des Stufenbandes beziehungsweise von dessen Bauteilen wie einer Förderkette 21 (siehe Figur 4), wie er typenspezifisch an einer physischen Fahrtreppe oder an einem physischen Fahrsteig durch deren Führungsschienen vorgegeben wird.

Selbstverständlich kann das typenspezifische, zweidimensionales Layout 223 auch durch eine manuelle Eingabe ausgewählt werden, wobei vorzugsweise vom Computerprogramm 200 überprüft wird, ob das dem ausgewählten, zweidimensionalen Layout 223 zugrundeliegende Produkt bestimmte kundenspezifische Konfigurierungsdaten 211 wie beispielsweise den Auflageabstand L_{X3} oder die Förderhöhe h_{Z} erfüllen kann.

Figur 3 zeigt wie bereits zur Figur 1 erklärt, in dreidimensionaler Ansicht ein angepasstes, zweidimensionales Layout 233. Das gemäss der Figur 2 vorgeschlagene oder durch manuelle Eingabe ausgewählte, zweidimensionale Layout 223 ist eine Vorlage, die zwar bereits den gewünschten Produkttyp beziehungsweise das gewünschte Produkt festlegt, jedoch aber noch nicht den kundenspezifischen Anforderungen 211 genügt. Insbesondere wird im Anpassungs-Verfahrensschritt 230 das ausgewählte, zweidimensionale Layout 223 der Figur 2 und unter Beibehaltung der Neigung α in der Förderhöhe hz angepasst. Die Anpassung kann ausgehend vom Nullpunkt N erfolgen, es können aber auch andere Stellen wie beispielsweise die Auflagestellen 255A, 255B oder Punkte im zweidimensionalen Layout 233 definiert sein, die bei der Anpassung der Förderhöhe hz herangezogen werden können. Dadurch weist das derart angepasste, zweidimensionale Layout 233 logischerweise auch einen grösseren Auflageabstand L_{X3} zwischen den Auflagestellen 225A, 225B und einen längeren Führungsweg 224, als die ursprünglich ausgewählte Vorlage auf. Bei zweidimensionalen Layouts von horizontalen Fahrsteigen 221 entfällt logischerweise eine Anpassung einer Förderhöhe hz, da die beiden Zutrittsbereiche immer auf derselben horizontalen Ebene angeordnet sind.

Figur 4 zeigt wie bereits zur Figur 1 erklärt, in dreidimensionaler Ansicht ein unterteiltes, zweidimensionales Layout 243. Dies kann dadurch erreicht werden, dass der Führungsweg 224 des gemäss der Figur 3 in der Förderhöhe angepassten, zweidimensionalen Layouts 233 durch die Initialerfassung 240 in Teilungsabschnitte 244 unterteilt wird.

Die Länge L_{A} der Teilungsabschnitte 244 entspricht dem Abstand von zwei aufeinander folgenden Gelenkstellen 22 einer typenspezifischen Förderkette 21, die in der Figur 4 der besseren Übersicht wegen, deutlich vergrössert dargestellt ist. Hierbei kann ein Rest-Teilungsabschnitt 245 übrigbleiben, dessen Restlänge L_{R} kleiner ist als die Länge L_{A} aller anderen Teilungsabschnitte 244. Eine typenspezifische Förderkette 21 ist diejenige Förderkette 21, die für denjenigen Fahrtreppen- oder Fahrsteigtypen vorgesehen ist, der dem typenspezifischen, zweidimensionalen Layout 223 beziehungsweise dem angepassten, zweidimensionalen Layout 233 beziehungsweise dem unterteilten zweidimensionalen Layout 243, zugrunde liegt.

Falls ein Rest-Teilungsabschnitt 245 vorhanden ist, wird der Führungsweg 224 bezüglich seiner Umlauflänge soweit vergrössert, dass der Rest-Teilungsabschnitt 245 die gleiche Länge L_{A} aufweist, wie die übrigen Teilungsabschnitte 244. Erst dadurch kann auf dem Führungsweg 224 eine typenspezifische Förderkette 21 umlaufend angeordnet werden, die nur ganze Kettenlaschen 23, 24 (oder präziser ausgedrückt, Kettenlaschen 23, 24 gleicher Teilung) aufweist, ohne bereits einen vorgesehenen Spannbereich der Förderkette 21 auszunutzen.

Da eine Förderkette üblicherweise aus schmalen Kettengliedern 23 mit einer Gliederbreite b1 und breiten Kettengliedern 24 mit einer Gliederbreite b2 zusammengesetzt ist, können die Enden 26 einer solchen Förderkette 21 nur dann miteinander verbunden werden, wenn an der als Gelenkstelle 22 ausgebildeten Fügungsstelle ein schmales Kettenglied 23 auf ein breites Kettenglied 24 trifft. Diese Bedingung setzt eine gerade Anzahl von Teilungsabschnitten 244 beziehungsweise Gelenkstellen 22 voraus. Bei einer ungeraden Anzahl von Teilungsabschnitten 244 kann daher in einem weiteren Verfahrensschritt der Führungsweg 224 bezüglich seiner Umlauflänge um einen weiteren Teilungsabschnitt 244 verlängert werden.

Grundsätzlich weist der Führungsweg 224 zwei in den Zutrittsbereichen 229A, 229B angeordnete Umlenkbereiche 246A, 246B und zwischen den Umlenkbereichen 246A, 246B einen Vorlaufabschnitt 247 und einen Rücklaufabschnitt 248 auf. Bei zweidimensionalen Layouts 222, 223 einer Fahrtreppe oder eines geneigten Fahrsteiges sind die Umlenkbereiche 246A, 246B in den weiter oben erwähnten, horizontalen Abschnitten 228A, 228B (siehe auch Figur 2) der Zutrittsbereiche 229A, 229B angeordnet. Der Vorlaufabschnitt 247 und der Rücklaufabschnitt 248 erstrecken sich in den horizontalen Abschnitten 228A, 228B, im geneigten Abschnitt 226 und in den Übergangsbogen 227A, 227B zwischen den horizontalen Abschnitten 228A, 228B und dem geneigten Abschnitt 226. Bei zweidimensionalen Layouts 221 von horizontal angeordneten Fahrsteigen 221 sind die Umlenkbereiche 246A, 246B ebenfalls in den Zutrittsbereichen 229A, 229B angeordnet und der Vorlaufabschnitt 247 und der Rücklaufabschnitt 248 erstrecken sich horizontal zwischen den beiden Umlenkbereichen 246A, 246B. Zur Vergrösserung des Führungsweges 224 kann der Vorlaufabschnitt 247 und der Rücklaufabschnitt 248 verlängert werden, indem, bei Fahrtreppen und geneigten Fahrsteigen unter Beibehaltung der Förderhöhe hz und beispielsweise ausgehend vom Nullpunkt N, einer der beiden Umlenkbereiche 246A, 246B linear versetzt wird.

Oder mit anderen Worten ausgedrückt, wird einer oder werden beide Umlenkbereiche 246A, 246B horizontal verschoben, bis der Rest-Teilungsabschnitt 245 dieselbe Länge wie die anderen Teilungsabschnitte 244 aufweist und, sofern eine Förderkette 21 mit breiten Kettengliedern 24 und schmalen Kettenglieder 23 vorgesehen ist, der gesamte Förderweg 224 in eine gerade Anzahl von Teilungsabschnitten 244 aufgeteilt werden kann. Obwohl die Figur 4 die Initialerfassung 240 des Förderweges 224 anhand eines zweidimensionalen Layouts eines Fahrsteiges 243 zeigt, kann die Initialerfassung 240 mutatis mutandis auch bei einem zweidimensionalen Layout eines horizontalen Fahrsteiges 221 angewendet werden.

Die Figuren 5 bis 8 zeigen wie bereits zur Figur 1 erklärt, den Überlagerungs-Verfahrensschritt 250 anhand des unterteilten zweidimensionalen Layouts 243 aus der Figur 4. Zur Überlagerung weist der in der Figur 1 dargestellte Regelsatz 60 Anordnungsroutinen auf, mittels denen beispielsweise der Führungsweg 224 des unterteilten, zweidimensionalen Layouts 243 analysiert wird und markante Stellen extrahiert werden. Im vorliegenden Ausführungsbeispiel der Figur 5 könnten das beispielsweise die Schnitt- beziehungsweise Knickstellen 255K zwischen den horizontalen Abschnitten 228A, 228B und dem geneigten Abschnitt 226 und/oder die Bogenmittelpunkte M in den Umlenkbereichen 246A, 246B sein.

Zur Überlagerung werden die Felder 251 vordefinierter Struktur (siehe auch Figur 1) beispielsweise aus einer Gruppe umfassend ein Standardfeld 254, eine obere Knicksektion 255B, eine untere Knicksektion 255A, eine Trennsektion 256 oder ein Ausgleichsfeld 257 ausgewählt. Gegebenenfalls können noch weitere Felder 251 vordefinierter Struktur vorhanden sein. Eine Knicksektion 255A, 255B weist hierbei einen geneigten Schenkel 255Z und einen horizontalen Schenkel 255Y auf.

Der Regelsatz 60 kann beispielsweise Befehlszeilen enthalten, die wie in den Figuren 5 und 6 dargestellt, zuerst eine Anordnung der beiden Knicksektionen 255A, 255B an den Knickstellen 255K vorgeben. Die Knicksektionen 255A, 255B können Führungsausrichtungspunkte 255S (siehe Figur 1) aufweisen, die am Führungsweg 224 des unterteilten, zweidimensionalen Layouts 243 ausgerichtet werden.

Wie in der Figur 6 am Beispiel der im unteren Zutrittsbereich angeordneten Knicksektion 255A dargestellt, können die horizontalen Schenkel 255X der Knicksektionen 255A, 255B durch eine Verschiebung bestimmter Knoten 255K, 255L um eine Verlängerungsdistanz ΔL an eine errechnete Knotenposition 255K', 255L' und eine damit verbundene Verlängerung von den in diesen neuen Knotenpositionen 255K', 255L' mündenden Stäben 255G, 255H dem in den kundenspezifischen Konfigurierungsdaten 211 festgelegten Auflageabstand L_{X3} angepasst werden. Diese Verschiebung der Knoten 255K, 255L an die neue Knotenpositionen 255K', 255L' kann beispielsweise ausgehend vom Nullpunkt N erfolgen. Anstelle einer Verschiebung von Knoten 255K, 255L, können beispielsweise auch Felder definierter Struktur 251 an den horizontalen Schenkeln 255X angefügt werden, wie dies anhand der oberen Knicksektion 255B durch ein Anfügen eines Standardfeldes 254 und eines Ausgleichfeldes 257 beispielhaft dargestellt ist.

Mit anderen Worten sind an dem mit Feldern 251 überlagerten, zweidimensionalen Layout 243 Auflagestellen 225A, 225B in den Bereichen der beiden Umlenkbereiche 246A, 246B vorgesehen. Sofern nach der Überlagerung der Felder 251 ein Auflageabstand der Auflagestellen nicht einem geforderten Auflageabstand L_{X3} der kundenspezifischen Konfigurierungsdaten 211 entspricht, wird der Auflageabstand durch Einfügen eines weiteren Feldes 251 oder durch eine Verlängerung eines Feldes 251 im Bereich mindestens eines der beiden Umlenkbereiche 246A, 246B vergrössert.

Wie in der Figur 7 dargestellt, kann gegebenenfalls der Auflageabstand L_{X3} zwischen den Auflagestellen 225A, 225B so lang sein, dass eine im Regelsatz 60 hinterlegte Sektionslänge Lxs überschritten wird. Diese Sektionslänge Lxs berücksichtigt beispielsweise fertigungstechnische Grenzen wie eine maximal zur Verfügung stehende Länge von Stahlprofilen oder transporttechnische Grenzen wie die nutzbare Länge eines nach internationalem Standard ISO 668 gefertigten Transportcontainers. Bei einer Überschreitung der Sektionslänge Lxs können durch den Regelsatz 60 so viele Trennstellen 259 eingefügt werden, dass keine der Sektionen die maximale Sektionslänge L_{XS} überschreitet. Hierbei kann die Aufteilung in gleich lange Sektionen erfolgen. Dies ist aber nicht zwingend. Gegebenenfalls kann sich die Aufteilung auch nach der maximalen Länge von Stahlprofilen oder der nutzbaren Transportlänge richten.

Sofern vom Regelsatz 60 eine Trennstelle 259 vorgesehen ist, kann dort vom Regelsatz 60 automatisch eine an der Trennstelle 259 und am Führungsweg 224 ausgerichtete Trennsektion 256 eingefügt werden. Eine Trennsektion 256 ist hierbei ein vordefiniertes Feld 251, welches vorzugsweise orthogonal zum Führungsweg 224 in der Trennstelle 259 zweigeteilt ist.

Das wie vorangehend beschriebene und teilweise durch Felder 251 überlagerte, zweidimensionale Layout 243, weist nun noch Lücken T₁, T₂ zwischen den bereits eingefügten Feldern 251 auf, die durch den Regelsatz 60 möglichst mit Standardfeldern 254 überlagert werden.

Wie auch in der Figur 8 dargestellt, reiht der Regelsatz 60 die Standardfelder 254 in den Lücken T₁, T₂ aneinander an und richtet diese am Führungsweg 224 aus. Standardfelder 254 sind Felder 251 gleicher Länge und gleicher Struktur beziehungsweise gleicher Anordnung von Knoten 253 und Stäben 252. Es wäre aber reiner Zufall, wenn die Lücken T₁, T₂ vollständig mit Standardfeldern 254 überlagert werden könnten. Im Regelfall bleibt eine Rest-Lücke T₃, T₄, die kürzer als ein Standardfeld 254 ist. Der Regelsatz 60 passt in jede dieser Lücken T₃, T₄, ein am Führungsweg 224 ausgerichtetes Ausgleichsfeld 257 ein. Dessen Struktur aus Knoten 253 und Stäben 252 gleicht derjenigen eines Standardfeldes 254, ist aber kürzer als das Standardfeld 254.

Die Figur 8 zeigt das vollständig mit Feldern 251 definierter Struktur überlagerte, zweidimensionale Layout 273. Allerdings kann die Rest-Lücke T₃, T₄, so schmal sein, dass kein vernünftig dimensioniertes Ausgleichsfeld 257 eingepasst werden kann. Für diesen Fall, beispielhaft durch die Rest-Lücke T₄ dargestellt, umfasst der Regelsatz 60 eine Überprüfungsroutine, mit der eine minimale Länge eines Ausgleichsfeldes 257 überprüft werden kann. Bei einer Unterschreitung von dessen minimaler Länge kann der Regelsatz 60 ein angrenzendes Standardfeld 254 oder eine angrenzende Hälfte einer Trennsektion 256 mit dem zu kurz geratenen Ausgleichsfeld 257 verbinden beziehungsweise verschmelzen und anschliessend dieses verbundene Feld in zwei gleich lange Ausgleichsfelder 257 unterteilen.

Auch nach der kompletten Überlagerung des zweidimensionalen Layouts 273 mit Feldern 251, kann selbstverständlich eine Trennstelle 259 durch eine manuelle Eingabe eingefügt werden. Wie die Figur 8 zeigt, wird hierbei ein Standardfeld 254 durch eine Trennsektion 256 gleicher Länge ersetzt. Vorzugsweise überprüft hierbei der Regelsatz 60, ob die gewählten Trennstellen 259 zu Sektionen führen, welche die im Regelsatz hinterlegte Sektionslänge Lxs überschreiten. Es ist durch eine manuelle Eingabe auch möglich, vom Regelsatz 60 vorgeschlagene Trennsektionen 256 durch Standardfelder 254 zu ersetzen, wobei bei einer Überschreitung der Sektionslänge Lxs das Computerprogramm eine entsprechende optische und/oder akustische Warnung ausgeben kann.

Wie in der Figur 9 dargestellt, können anschliessend im dreidimensionalen Raum zur darin angeordneten Ebene des zweidimensionalen Layouts 273 zwei parallele Ebenen E1, E2 definiert werden, wobei der typenspezifische Abstand dieser parallelen Ebenen E1, E2 mittels des Regelsatzes 60 aus der spezifizierten Stufenbreite B (siehe Figur 1) errechnet werden kann. Auf den beiden Ebenen E1, E2 können jeweils der definierten Struktur der Felder 251 folgend, aus Profilstab-Datensätzen 292 gebildete, dreidimensionale Fachwerkmodell-Abschnitte 911, 912 angeordnet werden.

Hierbei kann ein dreidimensionaler Fachwerkmodell-Abschnitt 911, 912 Datensätze eines Obergurt-Abschnitts 296, eines Untergurt-Abschnitts 293 mindestens eines Stehers 291 und mindestens einer Diagonalstrebe 294 aufweisen, deren graphische Repräsentationen gemäss der Struktur der Felder 251 auf den beiden Ebenen E1, E2, im dreidimensionalen Raum zueinander angeordnet sind.

Wie in der Figur 10 dargestellt, werden die einzelnen Fachwerkmodell-Abschnitte 911, 912, 913, 914 auf den beiden, in der Figur 10 der besseren Übersicht wegen nicht gezeichneten Ebenen E1, E2, entlang des zweidimensionalen Layouts 273 aneinandergefügt. Dadurch werden im dreidimensionalen Raum zwei zueinander parallel angeordnete, dreidimensionale Fachwerkmodell-Seitenteile gebildet, die in der Figur 10 nur teilweise abgebildet sind. Die Fachwerkmodell-Seitenteile sind im dreidimensionalen Raum angeordnete, dreidimensionale graphische Repräsentationen der aus den Profilstab-Datensätzen 292 zusammengesetzten Fachwerkseitenteil-Datensätze 951, 952. Diese sind ebenfalls im Computersystem 10 speicherbar.

Anschliessend können die zueinander parallel angeordneten Fachwerkseitenteil-Datensätze 951, 952 orthogonal zu deren Ebenen mittels Profilstab-Datensätzen 292, oder präziser ausgedrückt, mittels Querstreben-Datensätzen 295, Bodenquerstreben-Datensätzen 298, Boden-Diagonalstreben-Datensätzen 297 und Stirnseitenteil-Datensätzen 308 mit Auflagewinkel-Datensätzen 309 zum Fachwerk-Datensatz 301 ergänzt werden, dessen graphische Repräsentation ein dreidimensionales Fachwerkmodell ist. Hierzu sind im Regelsatz 60 typenspezifische Schnittstellendefinitionen hinterlegt, welche Verbindungsstellen 304 und Knoten 253 der Fachwerkmodell-Seitenteile beziehungsweise der Fachwerkseitenteil-Datensätze 951, 952 mit den Querstreben-Datensätzen 295, Bodenquerstreben-Datensätzen 298, Boden-Diagonalstreben-Datensätzen 297 und Stirnseitenteil-Datensätzen 308 miteinander verbunden werden müssen.

Wie weiter oben erläutert, werden die Fachwerkmodell-Seitenteile beziehungsweise Fachwerkseitenteil-Datensätze 951, 952 durch ein Aneinanderfügen von den Feldern 251 entsprechenden Fachwerkmodell-Abschnitten 911, 912, 913, 914, gebildet. Zur Optimierung einer zukünftigen Fertigung können nun mittels des Regelsatzes 60 aus den durch die Fachwerkmodell-Abschnitte 911, 912, 913, 914 definierten Obergurt-Abschnitten 296E, 296F, 296G der Fachwerkseitenteil-Datensätze 951, 952 ein oder mehrere durchgehende Obergurt-Datensätze 296H erzeugt werden, die die Obergurt-Abschnitte 296E, 296F, 296G im Fachwerk-Datensatz 301 ersetzen. Die Enden der durchgehenden Obergurt-Datensätze 296H, 296J können durch die folgenden Strukturmerkmale von Feldern 251 definiert werden: eine Trennstelle 259 der Trennsektion 256, eine Auflagestelle 225A, 225B, eine Knickstelle 255K der oberen Knicksektion 255B oder unteren Knicksektion 255A.

Gattungsgemäss können auch die Untergurt-Abschnitte 293V, 293W (der besseren Übersicht wegen sind nur zwei Untergurt-Abschnitte mit einem Bezugszeichen gekennzeichnet) der Fachwerkseitenteil-Datensätze 951, 952 in ein oder mehrere durchgehende Untergurt-Datensätze 293H zusammengefasst werden.

Unter dem Merkmal «durchgehend» ist in der vorliegenden Beschreibung ein durch den durchgehenden Obergurt-, oder Untergurt-Datensatz definierter, durchgehend einstückiger Profilstab zu verstehen. Das bedeutet im Wesentlichen, dass nicht einzelne Obergurt-, oder Untergurt- Abschnitte von einem langen Profilstab-Halbzeug abgesägt und die einzelnen Abschnitte wieder zusammengeschweisst werden müssen, sondern dass die Längen der Abschnitte addiert, und dann vom Profilstab-Halbzeug ein dementsprechend langer Profilstab abgesägt wird. Hierdurch kann bei der anschliessenden Produktion viel Sägearbeit und Schweissarbeit eingespart werden

Wie bereits erwähnt, können mittels des Regelsatzes 60 anhand der errechneten Stabkräfte F_{Sn} und der geometrischen Daten der entsprechenden Fachwerkmodell-Abschnitte 911, 912, 913, 914 die erforderlichen, vorzusehenden Schweissnahtlängen von sich überlappenden, Profilstäben eines Knotens 253 oder einer Verbindungsstelle 304 mit den in diesem Knoten 253 oder dieser Verbindungsstelle 304 vorhandenen geometrischen Verhältnissen verglichen werden. Bei zu kurzer Überlappung, kann für den jeweiligen Knoten 253 oder die jeweilige Verbindungsstelle 304 ein Knotenblech beziehungsweise ein Knotenblech-Datensatz 305 vorgesehen werden.

Selbstverständlich können auch andere Verbindungsarten berechnet werden, beispielsweise die Anzahl und der Durchmesser von Schrauben, Nieten oder Clinchstellen wenn in den Knoten 253 oder Verbindungsstellen 304 Schraubverbindungen, Clinchverbindungen oder Nietverbindungen zur Verbindung der Profilstäbe vorgesehen sind.

Aus den vorangehenden Ausführungen wird deutlich, dass der Regelsatz 60 nicht eine einfache Formel, sondern ein umfangreiches Computerprogramm beziehungsweise ein umfangreicher Teil des Computerprogramms 201 ist. Im Regelsatz 60 kann beispielsweise eine Datenbank integriert sein, in welcher die Materialkennwerte der in den verschiedensten Produktionsländern erhältlichen Materialien, an den einzelnen Produktionsstandorten verfügbaren Produktionsmittel wie der verfügbare Maschinenpark und dergleichen mehr hinterlegt sind. Es können aber auch eine Vielzahl von Algorithmen, beispielsweise zur geometrischen Analyse des Führungsweges 224, Berechnungsmethoden zur statischen und dynamischen Analyse des Fachwerk-Datensatzes 301 aus dem Gebiet der Physik, der technischen Mechanik und der Festigkeitslehre, sowie stochastische Berechnungsmetoden implementiert sein. Selbstverständlich kann der Regelsatz 60 auch eine Zugriffsregelung auf externe Computerprogramme und Datenbanken beinhalten, aus denen diese Algorithmen, Berechnungsprogramme wie beispielsweise ein Finite-Elemente-Programm und dergleichen mehr, abrufbar sind. Vorzugsweise ist in den einzelnen Feldern 251 hinterlegt, welche Berechnungsgrundlagen aus dem Regelsatz 60 bei seinen charakteristischen Eigenschaften zur Anwendung kommen.

Dadurch, dass der Fachwerk-Datensatz 301 eine virtuelle digitale Kopie des tatsächlichen, nach diesem hergestellten physischen Fachwerk ist, kann dieser in einen sogenannten Digitalen-Doppelgänger-Datensatz eingebunden werden, der seinerseits eine virtuelle Kopie der durch die kundenspezifischen Konfigurierungsdaten konfigurierten, physischen Fahrtreppe beziehungsweise Fahrsteig ist. Der Digitale-Doppelgänger-Datensatz bietet eine hervorragende Simulationsplattform, um von Sensoren erfasste Betriebsparameter der zugehörenden physischen Fahrtreppe oder des zugehörenden physischen Fahrsteiges zu analysieren. Die Simulationen können Rückschlüsse auf den aktuellen Zustand der Fahrtreppe oder des Fahrsteiges und insbesondere Rückschlüsse über eine eventuell notwendige Wartung oder Reparatur ermöglichen.

Obwohl die vorliegende Erfindung in den Figuren 1 bis 10 am Beispiel eines Fachwerk-Datensatzes 301 einer Fahrtreppe ausführlich beschrieben wurde, ist es offensichtlich, dass die beschriebenen Verfahrensschritte und das entsprechende Computersystem 10 gleichermaßen auch für Fahrsteige Anwendung finden. Zudem wurde die Anordnung der Profilstab-Datensätze 292 im dreidimensionalen Raum anhand von zwei Ebenen E1, E2 beschrieben. Dies ist kein zwingendes Vorgehen, denn es können beispielsweise auch vom Nullpunkt N ausgehende, räumliche Koordinaten aller Profilstab-Datensätze 292 errechnet werden, so dass diese dann auf den Nullpunkt N bezogen, angeordnet werden können. Es sind auch Lösungen mit Hilfs-Nullpunkten für jedes Feld 251 denkbar, um ausgehend von diesen die Profilstab-Datensätze anzuordnen.

Abschließend ist darauf hinzuweisen, dass Begriffe wie "aufweisend", "umfassend", etc. keine anderen Elemente oder Schritte ausschließen und Begriffe wie "eine" oder "ein" keine Vielzahl ausschließen. Ferner sei daraufhingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können sofern sie innerhalb des Schutzumfangs der nachfolgenden Ansprüche liegen. Bezugszeichen in den Ansprüchen sind nicht als Einschränkung anzusehen.

## Patentansprüche

1. Verfahren (200) zur Erstellung eines dreidimensionalen Fachwerk-Datensatzes (301) einer Fahrtreppe oder eines Fahrsteiges mittels eines in einem Computersystem (10) ausgeführten Computerprogramms (201), **dadurch gekennzeichnet, dass** mittels des Computerprogramms (201):
• kundenspezifische Konfigurierungsdaten (211) mit Angaben zumindest zur Förderhöhe (h_{Z}) und zur Stufenbreite (B) ermittelt werden;
• aufgrund der kundenspezifischen Konfigurierungsdaten (211) ein typenspezifisches, zweidimensionales Layout (221, 222, 223) durch das Computerprogramm (201) vorgeschlagen oder durch eine manuelle Eingabe ausgewählt wird, wobei dieses zweidimensionale Layout (221, 222, 223) in einer Ebene eines dreidimensionalen Raumes den Führungsweg (224) einer umlaufenden Förderkette (21) umfasst und einen definierten Nullpunkt (N) aufweist;
• dieses zweidimensionale Layout (221, 222, 223) ausgehend vom Nullpunkt (N) in der Förderhöhe (h_{z}) angepasst wird;
• der Führungsweg (224) des in der Förderhöhe (h_{z}) angepassten Layouts (233) in einer Initialerfassung (240) in Teilungsabschnitte (244) unterteilt wird, wobei die Länge der Teilungsabschnitte (244) mit Ausnahme eines allfälligen Rest-Teilungsabschnittes (245), dem Abstand von zwei aufeinander folgenden Gelenkstellen (22) einer typenspezifischen Förderkette (21) entspricht und wobei die Länge des allfälligen Rest-Teilungsabschnitts (245) kleiner ist als die anderen Teilungsabschnitte (244); und
• falls bei der Initialerfassung (240) ein Rest-Teilungsabschnitt (245) vorhanden ist, der Führungsweg (224) bezüglich seiner Umlauflänge soweit vergrössert wird, dass der Rest-Teilungsabschnitt (245) die gleiche Länge aufweist wie die übrigen Teilungsabschnitte (244).

2. Verfahren (200) nach Anspruch 1, wobei bei einer ungeraden Anzahl von Teilungsabschnitten (244) bei der Initialerfassung (240), der Führungsweg (224) bezüglich seiner Umlauflänge um einen weiteren Teilungsabschnitt (244) verlängert wird.

3. Verfahren (200) nach Anspruch 1 oder 2, wobei der Führungsweg (224) zwei Umlenkbereiche (246A, 246B) und zwischen den Umlenkbereichen (246A, 246B) einen Vorlaufabschnitt (247) und einen Rücklaufabschnitt (248) aufweist und zur Vergrösserung des Führungsweges (224) der Vorlaufabschnitt (247) und der Rücklaufabschnitt (248) verlängert werden, indem unter Beibehaltung der Förderhöhe (h_{z}) und ausgehend vom Nullpunkt (N), einer der beiden Umlenkbereiche (246A, 246B) linear versetzt wird.

4. Verfahren (200) nach Anspruch 3, wobei dem angepassten, zweidimensionalen Layout (233) mittels eines Regelsatzes (60) Felder (251) vordefinierter Struktur überlagert werden, wobei diese Felder (251) vordefinierter Struktur in fachwerktypischer Anordnung Stäbe (252) und Knoten (253) umfassen und durch die Überlagerung ein überlagertes, zweidimensionales Layout (273) geschaffen wird.

5. Verfahren (200) nach Anspruch 4, wobei zur Überlagerung die Felder (251) vordefinierter Struktur aus einer Gruppe umfassend ein Standardfeld (254), eine obere Knicksektion (255B), eine untere Knicksektion (255A), eine Trennsektion (256) oder ein Ausgleichsfeld (257) ausgewählt werden.

6. Verfahren (200) nach Anspruch 4 oder 5, wobei an dem mit Feldern (251) überlagerten, zweidimensionalen Layout (273) Auflagestellen (225A, 225B) in den beiden Umlenkbereichen (246A, 246B) vorgesehen sind und sofern nach der Überlagerung der Felder (251) ein Auflageabstand (L_{X3}) der Auflagestellen (225A, 225B) nicht einem geforderten Auflageabstand (L_{X3}) der kundenspezifischen Konfigurierungsdaten (211) entspricht, der Auflageabstand (L_{X3}) durch Einfügen eines weiteren Feldes (251) oder durch eine Verlängerung eines Feldes (251) im Bereich mindestens eines der beiden Umlenkbereiche (246A, 246B) vergrössert wird.

7. Verfahren (200) nach Anspruch 5 oder 6, wobei durch eine manuelle Eingabe über eine Schnittstelle (13) oder aufgrund der kundenspezifischen Konfigurierungsdaten (211), ein Standardfeld (254) oder ein Ausgleichsfeld (257) durch eine längengleiche Trennsektion (256) ersetzt wird.

8. Verfahren (200) nach einem der Ansprüche 5 bis 7, wobei der Regelsatz (60) eine Überprüfungsroutine umfasst, mit der eine minimale Länge eines Ausgleichsfeldes (257) überprüft und bei einer Unterschreitung von dessen minimaler Länge ein angrenzendes Standardfeld (254) oder eine Hälfte einer Trennsektion (256) mit dem zu kurz geratenen Ausgleichsfeld (257) verbunden wird und anschliessend dieses verbundene Feld (251) in zwei gleich lange Ausgleichsfelder (257) unterteilt wird.

9. Verfahren (200) nach einem der Ansprüche 4 bis 8, wobei Stabkräfte (F_{Sn}) in den Stäben (252) der einzelnen Felder (251) mittels des Regelsatzes (60) aus der Stufenbreite (B) und der Förderhöhe (H_{Z}) berechnet werden und anhand der Stabkräfte (F_{Sn}) eine typenspezifische Auswahl von Profilstab-Datensätzen (292) für dreidimensionale Fachwerkmodell-Abschnitte (911, 912, 913, 914) erfolgt, deren Profilstab-Datensätze (292) den Stäben (252) der Felder (251) entsprechend angeordnet sind und aus denen der zu erstellende Fachwerk-Datensatz (301) anhand des durch Felder (251) überlagerten zweidimensionalen Layouts (273) zusammengesetzt wird.

10. Verfahren (200) nach Anspruch 9, wobei im dreidimensionalen Raum zur darin angeordneten Ebene des überlagerten zweidimensionalen Layouts (273) zwei parallele Ebenen (E1, E2) vorhanden sind, auf denen jeweils der Struktur der Felder (251) entsprechend, aus Profilstab-Datensätzen (292) gebildete, dreidimensionale Fachwerkmodell-Abschnitte (911, 912, 913, 914) entlang des überlagerten zweidimensionalen Layouts (273) aneinandergefügt werden, so dass dadurch im dreidimensionalen Raum zwei zueinander parallel angeordnete Fachwerkmodell-Seitenteile (951, 952) gebildet werden, wobei aus der Stufenbreite (B) mittels des Regelsatzes (60) der Abstand dieser parallelen Ebenen E1, E2) beziehungsweise der Fachwerkmodell-Seitenteile (951, 952) zueinander, errechnet wird.

11. Verfahren (200) nach Anspruch 10, wobei die zueinander parallel angeordneten Fachwerkmodell-Seitenteile (951, 952) orthogonal zu deren Ebenen (E1, E2) mittels Profilstab-Datensätzen (292) aus einer Gruppe umfassend Querstreben-Datensätze (295), Bodenquerstreben-Datensätze (298), Boden-Diagonalstreben-Datensätze (297) und Stirnseitenteil-Datensätze (308) mit Auflagewinkeln (309) zum Fachwerk-Datensatz (301) miteinander verbunden werden.

12. Verfahren (200) nach Anspruch 10 oder 11, wobei ein dreidimensionaler Fachwerkmodell-Abschnitt (911, 912, 913, 914) Datensätze eines Obergurt-Abschnitts (296E, 296F, 296G, 296J) eines Untergurt-Abschnitts (293V, 293W) mindestens eines Stehers (291) und mindestens einer Diagonalstrebe (294) aufweist, deren virtuelle Entsprechungen gemäss der Struktur der Felder (251), auf den beiden Ebenen (E1, E2) im dreidimensionalen Raum zueinander angeordnet sind.

13. Verfahren (200) nach Anspruch 12, wobei aus den Obergurt-Abschnitten (296E, 296F, 296G) der Fachwerkmodell-Seitenteile (951, 952) ein oder mehrere durchgehende Obergurt-Datensätze (296H) erzeugt werden und/oder aus den Untergurt-Abschnitten (293V, 293W) der Fachwerkmodell-Seitenteile (951, 952) ein oder mehrere durchgehende Untergurt-Datensätze (293H) erzeugt werden, wobei deren Enden durch die folgenden Strukturmerkmale von Feldern (251) definiert werden: eine Trennstelle (259) der Trennsektion (256), eine Auflagestelle (225A, 225B), eine Knickstelle (255K) der oberen oder unteren Knicksektion (255A, 255B).

14. Verfahren (200) nach einem der Ansprüche 8 bis 13, wobei mittels des Regelsatzes (60) anhand der errechneten Stabkräfte (F_{Sn}) und der geometrischen Daten der entsprechenden Fachwerkmodell-Abschnitte (911, 912, 913, 914) die erforderlichen, vorzusehenden Schweissnahtlängen in den einzelnen Knoten (253) berechnet werden.

15. Verfahren (200) nach Anspruch 14, wobei mittels des Regelsatzes (60) die erforderliche Schweissnahtlänge von sich überlappenden, Verbindungsstellen bildenden Profilstab-Datensätze (292) eines Knotens (253) mit den in diesem Knoten (253) vorhandenen geometrischen Verhältnissen verglichen werden, wobei bei zu kurzen Verbindungsstellen, für den jeweiligen Knoten (253) ein Knotenblech-Datensatz (305) vorgesehen wird.

## Claims

1. A method (200) for creating a three-dimensional truss dataset (301) of an escalator or moving walkway by means of a computer program (201) executed in a computer system (10), **characterized in that** by means of a computer program (201):
• client-specific configuration data (211) with information at least on the conveyor high (h_{Z}) and on the step width (B) are determined;
• a type-specific, two-dimensional layout (221, 222, 223) based on the client-specific configuration data (211) is proposed by the computer program (201) or selected by manual input, wherein this two-dimensional layout (221, 222, 223) comprises, in a plane of a three-dimensional space, the guideway (224) of a revolving conveyor chain (21) and has a defined origin (N);
• this two-dimensional layout (221, 222, 223) is adapted, starting from the origin (N), in terms of the conveyor high (hz);
• the guideway (224) of the layout (233) adapted in terms of the conveyor high (h_{Z}) is subdivided, in an initial recording (240), into division portions (244), wherein the length of the division portions (244), except for a possible remnant division portion (245), corresponds to the spacing of two sequential hinge points (22) of a type-specific conveyor chain (21) and wherein the length of the possible remnant division portion (245) is less than that of the other division portions (244); and
• in the event that there is a remnant division portion (245) with the initial recording (240), the guideway (224) is enlarged in terms of its circumferential length until the remnant division portion (245) has the same length as the rest of the division portions (244).

2. The method (200) according to Claim 1, wherein the guideway (224) is lengthened in terms of its circumferential length by a further division portion (244) in the event of an uneven number of division portions (244) in the initial recording (240).

3. The method (200) according to Claim 1 or 2, wherein the guideway (224) has two deflection zones (246A, 246B) and a forward run portion (247) and a return portion (248) between the deflection zones (246A, 246B) and wherein in order to enlarge the guideway (224), the forward run portion (247) and the return portion (248) are lengthened by linearly displacing one of the two deflection zones (246A, 246B) starting from the origin (N) while maintaining the conveyor high (hz).

4. The method (200) according to Claim 3, wherein the adapted two-dimensional layout (233) is overlaid, by means of the set of rules (60), with fields (251) of predefined structure, wherein these fields (251) of predefined structure comprise bars (252) and nodes (253) in truss-like arrangement and wherein an overlaid two-dimensional layout (273) is created by the overlaying.

5. The method (200) according to Claim 4, wherein the fields (251) of predefined structure are selected for the overlay from a group comprising a standard field (254), a top bend section (255B), a bottom bend section (255A), a division section (256) or a compensation field (257).

6. The method (200) according to Claim 4 or 5, wherein bearing points (225A, 225B) are provided in the two deflection zones (246A, 246B) on the two-dimensional layout (273) overlaid with fields (251) and, if a bearing space (L_{X3}) of the bearing points (225A, 225B) does not correspond to a required bearing space (L_{X3}) of the client-specific configuration data (211), the bearing space (L_{X3}) is enlarged by inserting a further field (251) or by lengthening a field (251) in the region of at least one of the two deflection zones (246A, 246B).

7. The method (200) according to Claim 5 or 6, wherein a standard field (254) or a compensation field (257) is replaced by a division section (256) of equal length, either by a manual entry via an interface (13) or on the basis of the client-specific configuration data (211).

8. The method (200) according to any one of Claims 5 through 7, wherein the set of rules (60) comprises a test routine, with which a minimum length of a compensation field (257) is checked and, if the minimum length thereof is not achieved, an adjacent standard field (254) or a half of a division section (256) is combined with the compensation field (257) that has become too short and this combined field (251) is then subdivided into two equally long compensation fields (257).

9. The method (200) according to any one of Claims 4 through 8, wherein bar forces (F_{Sn}) in the bars (252) of the individual fields (251) are calculated, by means of the set of rules (60), from the step width (B) and the conveyor high (h_{Z}) and wherein a type-specific selection of profile bar datasets (292) for three-dimensional truss model portions (911, 912, 913, 914) is made on the basis of the bar forces (F_{Sn}), the profile bar datasets (292) of which portions are arranged according to the bars (252) of the fields (251) and from which the truss dataset (301) to be created is composed on the basis of the two-dimensional layout (273) overlaid with fields (251).

10. The method (200) according to Claim 9, wherein two planes (E1, E2) are present in the three-dimensional space which are parallel to the plane of the overlaid two-dimensional layout (273) arranged therein, on which planes three-dimensional truss model portions (911, 912, 913, 914) formed from profile datasets (292) are fit together along the overlaid two-dimensional layout (273) in a manner corresponding to the structure of the fields (251) in each case such that two truss model side parts (951, 952) arranged parallel relative to one another are formed in the three-dimensional space as a result, wherein the spacing of these parallel planes (E1, E2) or truss model datasets (951, 952) relative to one another is calculated from the step width (B) by means of the set of rules (60).

11. The method (200) according to Claim 10, wherein the truss model side parts (951, 952) arranged parallel relative to one another are interconnected, at right angles to their planes (E1, E2), by means of profile bar datasets (292) from a group comprising transverse strut datasets (295), transverse floor strut datasets (298), diagonal floor strut datasets (297) and end part datasets (308) with support brackets (309) for the truss dataset (301).

12. The method (200) according to Claim 10 or 11, wherein a three-dimensional truss model portion (911, 912, 913, 914) has datasets of a top beam portion (296E, 296F, 296G, 296J), of a bottom beam portion (293V, 293W), of at least one upright (291) and of at least one diagonal strut (294), virtual counterparts of which are arranged, according to the structure of the fields (251), relative to one another in the three-dimensional space on the two planes (E1, E2).

13. The method (200) according to Claim 12, wherein one or a plurality of continuous top beam datasets (296H) are generated from the top beam portions (296E, 296F, 296G) of the truss side parts (951, 952) and/or one or a plurality of continuous bottom beam datasets (293H) are generated from the bottom beam portions (293V, 293W) of the truss side parts (951, 952), wherein the ends thereof are defined by the following structural features of fields (251): a division point (259) of the division section (256), a bearing point (225A, 225B), a bend point (255K) of the top or bottom bend section (255A, 255B).

14. The method (200) according to any one of Claims 8 through 13, wherein the required weld seam lengths to be provided in the individual nodes (253) are calculated by means of the set of rules (60) on the basis of the calculated bar forces (F_{Sn}) and the geometric data of the corresponding truss model portions (911, 912, 913, 914).

15. The method (200) according to Claim 14, wherein the required weld seam lengths of overlapping, connection point-forming profile bar datasets (292) of a node (253) are compared, by means of the set of rules (60), to the existing geometric relationships in this node (253), wherein in the case of connection points that are too short, a gusset dataset (305) is provided for the node (253) concerned.

## Revendications

1. Procédé (200) permettant de créer un jeu de données d'ossature (301) tridimensionnel d'un escalier roulant ou d'un trottoir roulant au moyen d'un programme informatique (201) s'exécutant dans un système informatique (10), **caractérisé en ce qu'**au moyen du programme informatique (201) :
• des données de configuration spécifiques au client (211) sont déterminées à l'aide d'informations au moins sur la hauteur de transport (h_{z}) et la largeur des marches (B) ;
• sur la base des données de configuration spécifiques au client (211), une maquette bidimensionnelle (221, 222, 223) spécifique au type est proposée par le programme informatique (201) ou sélectionnée par entrée manuelle, ladite maquette bidimensionnelle (221, 222, 223) comprenant, dans un plan d'un espace tridimensionnel, le trajet de guidage (224) d'une chaîne de transport en circulation (21) et présentant un point zéro (N) défini ;
• ladite maquette bidimensionnelle (221, 222, 223) est ajustée au niveau de la hauteur de transport (h_{z}) à partir du point zéro (N) ;
• le trajet de guidage (224) de la maquette (233) ajustée au niveau de la hauteur de transport (h_{z}) est subdivisé en sections de division (244) dans une saisie initiale (240), la longueur des sections de division (244), à l'exception d'une éventuelle section de division restante (245), correspondant à la distance entre deux points d'articulation consécutifs (22) d'une chaîne de transport spécifique au type (21), et la longueur de l'éventuelle section de division restante (245) étant inférieure aux autres sections de division (244) ; et
• si une section de division restante (245) est présente lors de la saisie initiale (240), le trajet de guidage (224) est augmenté en ce qui concerne sa longueur circonférentielle jusqu'à ce que la section de division restante (245) présente la même longueur que les autres sections de division (244).

2. Procédé (200) selon la revendication 1, dans lequel, dans le cas d'un nombre impair de sections de division (244) lors de la saisie initiale (240), le trajet de guidage (224) est allongé d'une autre section de division (244) en ce qui concerne sa longueur circonférentielle.

3. Procédé (200) selon la revendication 1 ou 2, dans lequel le trajet de guidage (224) présente deux zones de renvoi (246A, 246B) et une section d'avance (247) et une section de retour (248) entre les zones de renvoi (246A, 246B), et, pour agrandir le trajet de guidage (224), la section d'avance (247) et la section de retour (248) sont allongées par le déplacement linéaire de l'une des deux zones de renvoi (246A, 246B) tout en maintenant la hauteur de transport (h_{z}) et en partant du point zéro (N).

4. Procédé (200) selon la revendication 3, dans lequel des panneaux (251) d'une structure prédéfinie sont superposés à la maquette bidimensionnelle (233) adaptée au moyen d'un jeu de règles (60), lesdits panneaux (251) de la structure prédéfinie dans un agencement typique d'ossature comprenant des barres (252) et des nœuds (253) et formant, en raison de la superposition, une maquette bidimensionnelle superposée (273).

5. Procédé (200) selon la revendication 4, dans lequel, aux fins de la superposition, les panneaux (251) de la structure prédéfinie sont choisis à partir d'un groupe comprenant un panneau standard (254), une section de coude supérieure (255B), une section de coude inférieure (255A), une section de séparation (256) ou un panneau de compensation (257).

6. Procédé (200) selon la revendication 4 ou 5, dans lequel des points d'appui (225A, 225B) sont prévus dans les deux zones de renvoi (246A, 246B) sur la maquette bidimensionnelle superposée (273) par des panneaux (251) et, si après la superposition des panneaux (251), une distance d'appui (L_{X3}) des points d'appui (225A, 225B) ne correspond pas à une distance d'appui (L_{X3}) requise par les données de configuration spécifiques au client (211), la distance d'appui (L_{X3}) est augmentée en insérant un panneau (251) supplémentaire ou en prolongeant un panneau (251) dans la zone d'au moins l'une des deux zones de renvoi (246A, 246B).

7. Procédé (200) selon la revendication 5 ou 6, dans lequel un panneau standard (254) ou un panneau de compensation (257) est remplacé par une section de séparation (256) de même longueur par une entrée manuelle par l'intermédiaire d'une interface (13) ou sur la base des données de configuration spécifiques au client (211).

8. Procédé (200) selon l'une des revendications 5 à 7, dans lequel le jeu de règles (60) comprend une routine de vérification permettant de vérifier une longueur minimale d'un panneau de compensation (257) et, si ladite longueur minimale n'est pas atteinte, un panneau standard (254) adjacent ou une moitié d'une section de séparation (256) est relié au panneau de compensation (257) qui s'est avéré trop court, puis ledit panneau (251) relié est divisé en deux panneaux de compensation (257) de longueur égale.

9. Procédé (200) selon l'une des revendications 4 à 8, dans lequel des forces de barres (F_{Sn}) dans les barres (252) des différents panneaux (251) sont calculées à l'aide du jeu de règles (60) à partir de la largeur des marches (B) et de la hauteur de transport (H_{z}), et, sur la base des forces de barres (F_{Sn}), une sélection spécifique au type de jeux de données de barres profilées (292) pour des sections de modèle d'ossature tridimensionnelles (911, 912, 913, 914) est effectuée, dont les jeux de données de barres profilées (292) sont disposés de manière correspondante aux barres (252) des panneaux (251), et à partir desquels le jeu de données d'ossature (301) à créer est assemblé sur la base de la maquette bidimensionnelle superposée (273) par des panneaux (251).

10. Procédé (200) selon la revendication 9, dans lequel deux plans parallèles (E1, E2) dans l'espace tridimensionnel pour le plan de la maquette bidimensionnelle superposée (273) disposée dans celui-ci sont présents, sur chacun desquels plans parallèles, en fonction de la structure des panneaux (251), respectivement des sections de modèle d'ossature tridimensionnelles (911, 912, 913, 914) formées à partir de jeux de données de barres profilées (292) sont assemblées le long de la maquette bidimensionnelle superposée (273), de sorte que deux parties latérales de modèle d'ossature (951, 952) parallèles l'une à l'autre sont formées dans un espace tridimensionnel, la distance entre lesdits plans parallèles (E1, E2) ou entre les parties latérales de modèle d'ossature (951, 952) étant calculée à partir de la largeur des marches (B) à l'aide du jeu de règles (60).

11. Procédé (200) selon la revendication 10, dans lequel les parties latérales de modèle d'ossature (951, 952) parallèles l'une à l'autre sont reliées entre elles de manière orthogonale à leurs plans (E1, E2) avec un angle d'appui (309) au moyen de jeux de données de barres profilées (292) issus d'un groupe comprenant des jeux de données d'entretoises transversales (295), des jeux de données d'entretoises transversales de plancher (298), des jeux de données d'entretoises diagonales de plancher (297) et des jeux de données de partie latérale de front (308), pour former le jeu de données d'ossature (301).

12. Procédé (200) selon la revendication 10 ou 11, dans lequel une section de modèle d'ossature tridimensionnelle (911, 912, 913, 914) présente des jeux de données d'une section de membrure supérieure (296E, 296F, 296G, 296J), d'une section de membrure inférieure (293V, 293W), d'au moins un montant (291) et d'au moins une entretoise diagonale (294) dont les équivalents virtuels sont disposés l'un par rapport à l'autre selon la structure des panneaux (251) sur les deux plans (E1, E2) dans l'espace tridimensionnel.

13. Procédé (200) selon la revendication 12, dans lequel un ou plusieurs jeux de données de membrure supérieure continus (296H) sont générés à partir des sections de membrure supérieure (296E, 296F, 296G) des parties latérales de modèle d'ossature (951, 952) et/ou un ou plusieurs jeux de données de membrure inférieure continus (293H) sont générés à partir des sections de membrure inférieure (293V, 293W) des parties latérales de modèle d'ossature (951, 952), les extrémités desdits jeux de données étant définies par les caractéristiques structurelles suivantes des panneaux (251) : un point de séparation (259) de la section de séparation (256), un point d'appui (225A, 225B), un point de coude (255K) de la section de coude supérieure ou inférieure (255A, 255B).

14. Procédé (200) selon l'une des revendications 8 à 13, dans lequel les longueurs de cordons de soudure requises et à prévoir sont calculées dans les différents nœuds (253) au moyen du jeu de règles (60) sur la base des forces de barres (F_{Sn}) calculées et des données géométriques des sections de modèle d'ossature (911, 912, 913, 914) correspondantes.

15. Procédé (200) selon la revendication 14, dans lequel, au moyen du jeu de règles (60), les longueurs de cordons de soudure requises de jeux de données de barres profilées (292) d'un nœud (253) se chevauchant et formant des points de liaison sont comparées aux rapports géométriques présents dans ledit nœud (253), un jeu de données de gousset (305) étant prévu pour le nœud (253) respectif si les points de liaison sont trop courts.
